# EUROPEAN PATENT APPLICATION

(11) **EP 4 831 970 A1**
(43) Date of publication of application: **28.10.2026**
(21) Application number: 24916464.1
(22) Date of filing: 27.09.2024
(51) Int. Cl.: G09F 9/30

(54) **EDGE PROTECTION ASSEMBLY AND FOLDING DEVICE**

(30) Priority: 08.01.2024 CN 202410034881
(71) Applicant: Huawei Technologies Co., Ltd., Shenzhen, Guangdong 518129 (CN)
(72) Inventor: LIU, Yu, Shenzhen, Guangdong 518129 (CN); CHEN, Yiyang, Shenzhen, Guangdong 518129 (CN); CAO, Jianbo, Shenzhen, Guangdong 518129 (CN); XIA, Chuxue, Shenzhen, Guangdong 518129 (CN); LIU, Guoqing, Shenzhen, Guangdong 518129 (CN)
(74) Representative: Gill Jennings & Every LLP
(86) International application number: PCT/CN2024/121812
(87) International publication number: WO 2025/148413

(57) **Abstract**

An edge protection assembly (100) and a foldable device (1000) are provided. The edge protection assembly (100) includes a fastening member (110), a supporting member (120), and a flexible embedded member (130). An elastic sheet (131) is embedded in a flexible body (132) to integrally form the flexible embedded member (130), the flexible body (132) is prone to bending and deformation, and the elastic sheet (131) plays a reinforcement role. The fastening member (110) is fastened to a hinge assembly (200), the supporting member (120) is fastened to the fastening member (110), and a middle part (130a) of the flexible embedded member (130) in a length direction is connected to the supporting member (120). The flexible embedded member (130) is fixed in the middle and free to move at both ends. The flexible embedded member (130) can keep covering a part of an edge of a display surface (300a) of a flexible display (300) to protect an edge of a bending region (302). Under prolonged repeated bending, static bending, or high-temperature and high-humidity conditions, deformation of the flexible embedded member (130) is small, and the flexible embedded member (130) is not prone to creasing, arching, or detachment, and can be restored to a flat natural form when being in an unfolded state, so that reliability is high. The flexible embedded member (130) facilitates formation of a uniform bending form during bending of the flexible display (300), reduces compression forces between the flexible embedded member (130) and the flexible display (300) in a folding process, and prevents the flexible display (300) from sustaining crack damage due to compression.

## Description

This application claims priority to Chinese Patent Application No. 202410034881.2, filed with the China National Intellectual Property Administration on January 8, 2024 and entitled "EDGE PROTECTION ASSEMBLY AND FOLDABLE DEVICE", which is incorporated herein by reference in its entirety.

### TECHNICAL FIELD

Embodiments of this application relate to the field of electronic device technologies, and in particular, to an edge protection assembly and a foldable device.

### BACKGROUND

When a foldable device in a related technology is in an unfolded state, a flexible display can provide a display region with a large area, and when the foldable device is in a folded state, an entire device structure is compact, and portability is good. An edge protection assembly may be disposed at a position of an edge of a bending region of the flexible display, to shield and protect the edge of the bending region of the flexible display. The edge protection assembly in the related technology is prone to plastic deformation after being bent for a long time, has difficulty restoring to a natural form when being in an unfolded state, and is prone to problems of creasing and arching.

### SUMMARY

Embodiments of this application provide an edge protection assembly and a foldable device, to resolve a problem that an edge protection assembly in a related technology is prone to creasing and arching after being bent for a long time.

The following technical solutions are used in embodiments of this application.

According to a first aspect, the edge protection assembly provided in embodiments of this application is applied to a foldable device having a hinge assembly and a flexible display. The edge protection assembly includes a fastening member, a supporting member, and a flexible embedded member. The fastening member is configured to be fastened to the hinge assembly. In an axial direction of the hinge assembly, a projection of the fastening member covers a part of a side surface of the flexible display. The supporting member is fastened to the fastening member. In a thickness direction of the flexible display, a projection of the flexible embedded member covers an edge of a bending region of a display surface of the flexible display. A middle part of the flexible embedded member in a length direction is connected to the supporting member. The flexible embedded member includes an elastic sheet and a flexible body, where the elastic sheet is embedded in the flexible body, and the elastic sheet and the flexible body are of an integrally formed structure.

An arrangement direction of a first main body and a second main body of the foldable device in an unfolded state is defined as an X direction, a width direction of the foldable device or the axial direction of the hinge assembly is defined as a Y direction, the thickness direction of the foldable device is defined as a Z direction, a thickness direction of the flexible display in an unfolded state is also defined as the Z direction, and the X direction, the Y direction, and the Z direction are perpendicular to each other.

The side surface of the flexible display is an outer circumferential surface connecting the display surface and a back surface. The length direction (X direction) of the flexible embedded member is perpendicular to the axial direction (Y direction) of the hinge assembly. The middle part of the flexible embedded member in the length direction (X direction) may not be an exact middle position in the length direction, but a middle region of the flexible embedded member in the length direction.

According to the edge protection assembly provided in this embodiment of this application, the elastic sheet is embedded in the flexible body, to integrally form the flexible embedded member, the flexible body is prone to bending and deformation, and the elastic sheet plays a reinforcement role. The fastening member is fastened to the hinge assembly, the supporting member is fastened to the fastening member, and the middle part of the flexible embedded member in the length direction is connected to the supporting member. In a process in which the foldable device switches between the unfolded state and the folded state, the middle part of the flexible embedded member is fixed, and the two ends move freely. The flexible embedded member can keep covering the edge of the bending region of the display surface of the flexible display, to protect the edge of the bending region, thereby preventing external foreign objects such as dust and water from entering the flexible display, and improving aesthetics of a position of the edge of the bending region of the flexible display. Under prolonged repeated bending, static bending, or high-temperature and high-humidity conditions, deformation of the flexible embedded member is small, and the flexible embedded member is not prone to creasing, arching, or detachment, and can be restored to a flat natural form when being in an unfolded state, so that user experience is good, reliability is high, and a folding life is long. The flexible embedded member facilitates formation of a uniform bending form during bending of the flexible display, reduces mutual compression forces between the flexible embedded member and the flexible display in a folding process, and prevents the flexible display from sustaining crack damage due to compression.

In an optional implementation, a material of the fastening member may be metal or plastic. A material of the supporting member may be metal or plastic. This facilitates reliably connecting the fastening member to the hinge assembly and reliably connecting the supporting member to the fastening member. The metal material may be stainless steel, cast iron, aluminum alloy, magnesium alloy, or the like.

In an optional implementation, the fastening member and the supporting member may be manufactured by using a metal injection process, have high dimensional precision and good structural strength, and can provide good protection effect for the edge of the flexible display. Alternatively, the fastening member and the supporting member may be manufactured by using a process such as die casting molding.

In an optional implementation, the supporting member and the fastening member may be approximately plate-shaped, and a thickness direction of the fastening member and a thickness direction of the supporting member are the axial direction (Y direction) of the hinge assembly.

In an optional implementation, the fastening member may include an insertion portion and an assembling portion, where the insertion portion is connected to the assembling portion. The insertion portion is configured to be inserted into the hinge assembly, and the assembling portion is configured to be connected to the supporting member.

In an optional implementation, a length of the insertion portion in the X direction is less than a length of the assembling portion in the X direction, the insertion portion and the assembling portion are approximately T-shaped, to facilitate inserting the insertion portion into the hinge assembly, and two ends of the assembling portion abut against a surface of the hinge assembly, thereby limiting the fastening member.

In an optional implementation, there is a mounting groove on a side that is of the fastening member and that faces the flexible embedded member, and the supporting member is embedded in the mounting groove. In this way, the supporting member and the fastening member occupy little space in the axial direction (Y direction) of the hinge assembly.

In an optional implementation, the fastening member may be bonded through adhesive, snap-fitted, welded, or connected through a fastener (such as a screw) to the supporting member.

In an optional implementation, both the supporting member and the fastening member are approximately plate-shaped, the supporting member is embedded in the mounting groove of the fastening member, and a snap fit of the supporting member is snap-fitted into a slot of the fastening member, so that the supporting member is reliably fastened to the fastening member.

In an optional implementation, shapes of the snap fit and the slot are set to adapt to each other, so that the snap fit is stably snap-fitted into the slot. For example, a cross section of the snap fit is cylindrical, and a cross section of the slot is cylindrical; or the snap fit extends in an L shape, and a cross section of the slot is rectangular.

In an optional implementation, both the supporting member and the fastening member are approximately plate-shaped, and the supporting member is welded to the fastening member, so that the supporting member is reliably fastened to the fastening member.

In an optional implementation, both the supporting member and the fastening member are approximately plate-shaped, and a fastener penetrates the supporting member and is in threaded connection to the fastening member, so that the supporting member is reliably fastened to the fastening member.

In an optional implementation, the flexible embedded member may be approximately set to be of a long strip structure. Both the elastic sheet and the flexible body in the flexible embedded member may extend along the edge of the bending region of the flexible display, so that the elastic sheet is closely connected to the flexible body. The flexible embedded member may be of a long strip structure that is straight, partially curved, or with a specific radian.

In an optional implementation, the elastic sheet has a first surface and a second surface that face away from each other, the first surface and the edge of the bending region of the display surface of the flexible display are disposed facing each other, and the flexible body is disposed on the second surface. The flexible embedded member with a small thickness may be obtained by using an integral forming process. For example, a thickness of the flexible embedded member is approximately 0.1 millimeters. This facilitates thinning of the entire foldable device. A part of the flexible body is used as an appearance surface, and a top of the flexible body can be seen from the outside, but the elastic sheet cannot be seen, so that the flexible embedded member has good aesthetics.

In an optional implementation, the elastic sheet may be a plastic sheet or a metal sheet, a material of the flexible body may be soft adhesive, and the elastic sheet and the flexible body are of an insert injection-molded structure. The elastic sheet is used as the insert, and injection molding is performed to obtain the flexible body that wraps the elastic sheet. The elastic sheet and the flexible body are combined to complement each other, and are connected stably, to form the integrated flexible embedded member. An overall thickness and a weight are small, and reliability is high.

In an optional implementation, the elastic sheet may be a plastic sheet, for example, a polyethylene terephthalate sheet or a polyimide sheet. The elastic sheet may alternatively be a metal sheet, for example, a steel sheet.

In an optional implementation, the material of the flexible body may be soft adhesive that is high-temperature-resistant and high-humidity-resistant, for example, silica gel, thermoplastic elastomer, thermoplastic urethane, polyvinyl chloride soft adhesive, rubber (such as silicone rubber, natural rubber, butadiene rubber, styrene-butadiene rubber, ethylene propylene rubber), or another material.

In an optional implementation, there is a first groove on a side that is of the flexible body and that faces the display surface of the flexible display, and the elastic sheet is embedded in the first groove, so that the flexible body is used as an appearance member, and the flexible body wraps a surface of the elastic sheet, thereby increasing a connection area between the flexible body and the elastic sheet. In this way, the flexible body and the elastic sheet are reliably connected.

In an optional implementation, the fastening member has a protruding first positioning portion, the supporting member has a protruding second positioning portion, and the first positioning portion and the second positioning portion clamp the middle part of the flexible embedded member.

The first positioning portion of the fastening member and the second positioning portion of the supporting member are used to clamp the middle part of the flexible embedded member, the fastening member is fastened to the hinge assembly, and the supporting member is fastened to the fastening member, so that the middle part of the flexible embedded member is rigidly fixed (fixed in the Z direction), and the two ends are soft and move freely. In this embodiment, a total thickness of the first positioning portion, the second positioning portion, and the flexible embedded member clamped by the first positioning portion and the second positioning portion is smaller, which helps reduce an overall thickness at a position, of the foldable device, corresponding to the middle part of the flexible embedded member.

In an optional implementation, on a basis that the first positioning portion of the fastening member and the second positioning portion of the supporting member clamp the middle part of the flexible embedded member, a third positioning portion is disposed between the first positioning portion and the second positioning portion, the middle part of the flexible embedded member in the length direction has a positioning hole, and the third positioning portion penetrates the positioning hole. The third positioning portion penetrates the positioning hole of the middle part of the flexible embedded member, so that the middle part of the flexible embedded member is reliably fastened to the supporting member.

In an optional implementation, the third positioning portion is disposed on a side that is of the second positioning portion and that faces the first positioning portion, and an end that is of the third positioning portion and that faces away from the second positioning portion is connected to or in contact with the first positioning portion. This facilitates molding and assembling of the fastening member having the first positioning portion and the supporting member having the second positioning portion and the third positioning portion.

In an optional implementation, the fastening member having the first positioning portion and the supporting member having the second positioning portion and the third positioning portion are both metal members. The third positioning portion on the second positioning portion of the supporting member penetrates the positioning hole of the middle part of the flexible embedded member, and an end portion of the third positioning portion is welded to the first positioning portion of the fastening member, so that the supporting member is reliably fastened to the fastening member. The first positioning portion and the second positioning portion jointly clamp the flexible embedded member, so that the middle part of the flexible embedded member is reliably fastened to the supporting member.

In an optional implementation, the third positioning portion may be disposed on a side that is of the first positioning portion and that faces the second positioning portion, and an end that is of the third positioning portion and that faces away from the first positioning portion is connected to or in contact with the second positioning portion.

In an optional implementation, the flexible body includes a strip portion and a connecting portion, the strip portion is connected to the elastic sheet, the strip portion has a first side surface facing the fastening member, and the connecting portion is connected to a middle part of the first side surface of the strip portion. The supporting member is embedded in the connecting portion, and the supporting member, the elastic sheet, and the flexible body are of an integrally formed structure.

The supporting member is embedded in the connecting portion, to support the middle part of the flexible embedded member. The fastening member is fastened to the hinge assembly, the supporting member is assembled on and fastened to the fastening member, and the flexible embedded member is soft as a whole, so that the middle part of the flexible embedded member is flexibly fixed, and the two ends are soft and move freely. In this embodiment, the thickness of the flexible embedded member is very small, which helps reduce an overall thickness at a position, of the foldable device, corresponding to the middle part of the flexible embedded member.

In an optional implementation, the fastening member is approximately plate-shaped, and the connecting portion may be plate-shaped, so that a thickness direction of the connecting portion and the thickness direction of the fastening member are the same, and are both disposed in the Y direction. In this way, a structure occupies little space in the Y direction, and the structure is compact.

In an optional implementation, the supporting member includes a supporting portion and an assembly portion connected to the supporting portion, the supporting portion is embedded in the connecting portion, and the assembly portion is connected to the fastening member. The supporting member is used as an insert, and the connecting portion is injection-molded, so that the supporting member is embedded in the connecting portion, and the supporting member and the connecting portion are closely connected. The assembly portion of the supporting member is a part configured to connect to the fastening member.

In an optional implementation, the assembly portion and the fastening member may be connected through a snap fit, adhesive bonding, welding, or a fastener (such as a screw), or in another manner.

In an optional implementation, the assembly portion may be snap fits disposed at two opposite ends of the supporting portion. The two snap fits can be snap-fitted into two slots of the fastening member, to fasten the supporting member to the fastening member.

In an optional implementation, the assembly portion is embedded in the mounting groove of the fastening member, and the assembly portion is bonded to the bottom surface of the mounting groove of the fastening member through adhesive.

In an optional implementation, the connecting portion is located between the fastening member and the supporting portion, there is an accommodating groove on a side that is of the fastening member and that faces the supporting member, and the connecting portion is embedded in the accommodating groove. In this way, the connecting portion occupies little space, and a size of the edge protection assembly in the axial direction of the hinge assembly is small, to facilitate having more space on the hinge assembly for assembling other components.

In an optional implementation, the supporting portion has a first fitting hole, the connecting portion has a first fitting column, the first fitting column is embedded in the first fitting hole, and a wall surface of the first fitting hole is connected to an outer circumferential surface of the first fitting column. In this way, the connecting portion and the supporting portion are closely connected.

In an optional implementation, the supporting portion has a bent section that bends and extends toward the strip portion, and the bent section is embedded in a connection region between the connecting portion and the strip portion. The bent section can provide a better support function for the middle part of the flexible embedded member in the length direction.

In an optional implementation, the bent section may not be disposed on the supporting portion, and the supporting portion that vertically extends can still support the middle part of the flexible embedded member in the length direction.

In an optional implementation, there is a limiting portion at each of two ends of a side surface that is of the flexible embedded member and that faces the fastening member, and the limiting portion extends in the thickness direction (Z direction) of the flexible display.

In the axial direction (Y direction) of the hinge assembly, a third gap is formed between the first side frame and a side surface of the flexible display, and a fourth gap is formed between the second side frame and the side surface of the flexible display. The limiting portion at one end of the flexible embedded member is located in the third gap, and the limiting portion at the other end of the flexible embedded member is located in the fourth gap. In this way, the two ends of the flexible embedded member move freely along with the first main body and the second main body, and the flexible embedded member is kept at the edge of the flexible display, and is not easily detached from the edge of the flexible display, to reliably shield and protect the edge of the flexible display, and prevent the flexible embedded member from being detached under action of an external force.

In an optional implementation, the limiting portion may be set to be sheet-shaped, to facilitate assembling the limiting portion in the gap between the first side frame (the second side frame) and the flexible display.

In an optional implementation, the limiting portion includes a flexible portion and a reinforcement portion, the flexible portion is connected to the flexible body, the reinforcement portion is embedded in the flexible portion, and the limiting portion, the elastic sheet, and the flexible body are of an integrally formed structure. The flexible portion and the reinforcement portion are combined to complement each other, and are connected stably.

In an optional implementation, the flexible portion has a second groove, and the reinforcement portion is embedded in the second groove. The flexible portion wraps the reinforcement portion, to increase a connection area between the flexible portion and the reinforcement portion, so that the flexible portion and the reinforcement portion are reliably connected.

In an optional implementation, the reinforcement portion has a second fitting hole, the flexible portion has a second fitting column, the second fitting column is embedded in the second fitting hole, and a wall surface of the second fitting hole is connected to an outer circumferential surface of the second fitting column. In this way, the flexible portion and the reinforcement portion are closely connected.

In an optional implementation, the limiting portion is the flexible portion, the flexible portion is connected to the flexible body, and the limiting portion, the elastic sheet, and the flexible body are of an integrally formed structure. The structure is easily molded, and connections between the flexible portion and the flexible body, and between the flexible body and the elastic sheet are reliable.

According to a second aspect, an embodiment of this application provides a foldable device, including a hinge assembly, a first main body, a second main body, a flexible display, and the edge protection assembly. The hinge assembly is located between the first main body and the second main body, and the first main body and the second main body are connected through the hinge assembly. The flexible display has a display surface and a back surface that face away from each other. The back surface of the flexible display is fastened to the first main body and the second main body. The edge protection assembly may be disposed on the hinge assembly, to shield and protect an edge of the bending region of the flexible display, thereby preventing external foreign objects such as dust and water from entering the flexible display, and improving aesthetics of a position of the edge of the bending region of the flexible display. The fastening member is fastened to the hinge assembly, and the supporting member is fastened to a side that is of the fastening member and that faces a side surface of the flexible display. In this way, little space is occupied.

In an optional implementation, a first side frame is disposed on the first main body, and a second side frame is disposed on the second main body. In a thickness direction (Z direction) of the flexible display, a first gap is formed between the first side frame and the display surface of the flexible display, and a second gap is formed between the second side frame and the display surface of the flexible display. One end of the flexible embedded member is located in the first gap, and the other end of the flexible embedded member is located in the second gap. In this way, the two ends of the flexible embedded member are limited. One end of the flexible embedded member may freely move relative to the first side frame and the flexible display, and the other end of the flexible embedded member may freely move relative to the second side frame and the flexible display, thereby preventing the flexible embedded member from being detached from a predetermined position.

In an optional implementation, there is a first shielding portion at a position that is of the first side frame and that is close to the hinge assembly, and there is a second shielding portion at a position that is of the second side frame and that is close to the hinge assembly. In the axial direction (Y direction) of the hinge assembly, a projection of the first shielding portion partially covers the fastening member, and a projection of the second shielding portion partially covers the fastening member, to protect the fastening member. This protects the fastening member, prevents an external foreign object, such as a particle, from entering a gap between the fastening member and the hinge assembly, improves reliability, and improves an appearance of the end portion of the hinge assembly.

In an optional implementation, one end of the first main body and one end of the second main body may rotate relative to the hinge assembly, and one end of the first main body away from the hinge assembly and one end of the second main body away from the hinge assembly may move close to or away from each other. The flexible display may be bent or unfolded as positions of the first main body and the second main body change, so that the foldable device switches between an unfolded state, an intermediate state, and a folded state.

In an optional implementation, the flexible display has a first fastening region, a bending region, and a second fastening region that are sequentially connected. The first fastening region is fastened to the first main body, the second fastening region is fastened to the second main body, and the bending region and the hinge assembly are correspondingly disposed.

In an optional implementation, the hinge assembly may include a hinge body, a hinge housing, a first plate body, and a second plate body. Both the hinge body and the hinge housing extend in the Y direction. The hinge body is disposed close to the flexible display, and the hinge housing is disposed on a side that is of the hinge body and that faces away from the flexible display. The first plate body and the second plate body are respectively connected to two sides of the hinge body in the X direction, and can rotate relative to the hinge body. The first plate body and the second plate body may be fastened to the first main body and the second main body in a one-to-one correspondence through a fastener or in another manner, so that the first main body and the second main body can rotate relative to the hinge body.

In an optional implementation, both the first main body and the second main body may include a middle housing and a rear housing. The middle housing may be referred to as a middle frame. The rear housing is disposed on a side that is of the middle housing and that faces away from the flexible display. The middle housing and the rear housing may be of an assembly structure. The middle housing and the rear housing may alternatively be of an integrally formed structure.

In an optional implementation, the first side frame is disposed on the first main body, and the first side frame is disposed on an edge that is of the flexible display and that corresponds to the first main body. The second side frame is disposed on the second main body, and the second side frame is disposed on an edge that is of the flexible display and that corresponds to the second main body. The first side frame may shield and protect an edge of the first fastening region of the flexible display, and the second side frame may shield and protect an edge of the second fastening region of the flexible display, to prevent the edge of the flexible display from being damaged and improve appearance effect.

In an optional implementation, the first main body and the first side frame may be of an assembly structure. The first main body and the first side frame may alternatively be of an integrally formed structure. The second main body and the second side frame may be of an assembly structure. The second main body and the second side frame may alternatively be of an integrally formed structure.

In an optional implementation, one edge protection assembly may be disposed on each of two end portions of the hinge assembly, to shield and protect edges, of the bending region of the flexible display, corresponding to the two end portions of the hinge assembly.

### BRIEF DESCRIPTION OF DRAWINGS

FIG. 1 is a diagram of fitting between an edge protection assembly and a flexible display in a foldable device according to an embodiment of this application;
FIG. 2 is a diagram of a structure of a foldable device in an unfolded state according to an embodiment of this application;
FIG. 3 is a diagram of a structure of the foldable device in FIG. 2 in a folded state;
FIG. 4 is a three-dimensional exploded view of the foldable device in FIG. 2;
FIG. 5 is a diagram of a structure of the foldable device in FIG. 2 from which a first side frame is detached;
FIG. 6 is a diagram of structures of a display, an edge protection assembly, and a hinge assembly in the foldable device in FIG. 2;
FIG. 7 is a diagram of assembly of the display, the edge protection assembly, and the hinge assembly in FIG. 6;
FIG. 8 is a three-dimensional diagram of assembly of an edge protection assembly according to an embodiment of this application;
FIG. 9 is a three-dimensional diagram of assembly of the edge protection assembly in FIG. 8 from another angle;
FIG. 10 is a three-dimensional exploded view of the edge protection assembly in FIG. 8;
FIG. 11 is a partial sectional view of the foldable device in FIG. 2 along a line A-A;
FIG. 12 is a partial sectional view of the foldable device in FIG. 2 along a line B-B;
FIG. 13 is a three-dimensional diagram of assembly of the edge protection assembly in FIG. 8 from another angle;
FIG. 14 is a three-dimensional exploded view of the edge protection assembly in FIG. 13;
FIG. 15 is a three-dimensional sectional view of the edge protection assembly in FIG. 8 along a line C-C;
FIG. 16 is a three-dimensional diagram of assembly of an edge protection assembly according to another embodiment of this application;
FIG. 17 is a three-dimensional diagram of assembly of the edge protection assembly in FIG. 16 from another angle;
FIG. 18 is a three-dimensional exploded view of the edge protection assembly in FIG. 16;
FIG. 19 is a further three-dimensional exploded view of the edge protection assembly in FIG. 18;
FIG. 20 is a three-dimensional sectional view of the edge protection assembly in FIG. 16 along a line D-D;
FIG. 21 is a diagram of a structure of a foldable device in an unfolded state according to another embodiment of this application;
FIG. 22 is a diagram of fitting between a display and an edge protection assembly in the foldable device in FIG. 21; and
FIG. 23 is a partial sectional view of the foldable device in FIG. 21 along a line E-E.

### Reference numerals:

1: shielding member; 1a: soft adhesive; 1b: steel sheet; 2: flexible display;
1000: foldable device;
100: edge protection assembly;
110: fastening member; 111: insertion portion; 112: assembling portion; 113: mounting groove; 114: first positioning portion; 115: accommodating groove; 116: slot;
120: supporting member; 121: second positioning portion; 122: third positioning portion; 123: supporting portion; 1231: first fitting hole; 1232: bent section; 124: assembly portion; 125: snap fit;
130: flexible embedded member; 130a: middle part; 130b: end; 131: elastic sheet; 131a: first surface; 131b: second surface; 132: flexible body; 1321: first groove; 132a: strip portion; 1322: first side surface; 1322a: middle part; 132b: connecting portion; 1323: first fitting column; 133: positioning hole; 134: limiting portion; 134a: flexible portion; 1341: second groove; 1342: second fitting column; 134b: reinforcement portion; 1343: second fitting hole;
200: hinge assembly; 200a: end portion; 210: hinge body; 220: hinge housing; 230: first plate body; 240: second plate body;
300: flexible display; 300a: display surface; 300b: back surface; 300c: side surface; 301: first fastening region; 302: bending region; 303: second fastening region;
400: first main body; 410: middle housing; 420: rear housing; 500: second main body;
600: first side frame; 601: opening; 602: first shielding portion; 611: first gap; 612: second gap; 613: third gap; 700: second side frame; 701: opening; 702: second shielding portion.

### DESCRIPTION OF EMBODIMENTS

To make technical problems to be resolved, technical solutions, and beneficial effects of this application clearer, the following further describes this application in detail with reference to accompanying drawings and embodiments. It should be understood that the specific embodiments described herein are merely used to explain this application but are not intended to limit this application. Although this application is described with reference to some embodiments, it does not mean that a characteristic of this application is limited only to this implementation. On the contrary, a purpose of describing this application with reference to an implementation is to cover another option or modification that may be derived based on claims of this application. To provide an in-depth understanding of this application, the following descriptions include a plurality of specific details. This application may be alternatively implemented without using these details. In addition, to avoid confusion or blurring a focus of this application, some specific details are omitted from the description. It should be noted that embodiments in this application and the features in embodiments may be mutually combined in the case of no conflict.

It should be noted that when an element is referred to as "fastened to" or "disposed on" another element, the element may be directly or indirectly on the another element. When an element is referred to as "connected to" another element, the element may be directly or indirectly connected to the another element.

It should be understood that in descriptions of embodiments of this application, it should be noted that, unless otherwise clearly specified and limited, terms "installation" and "connection" should be understood in a broad sense. For example, "connection" may be a detachable connection, a nondetachable connection, a direct connection, or an indirect connection through an intermediate medium. Orientation or position relationships indicated by terms "length", "width", "upper", "lower", "front", "rear", "left", "right", "vertical", "horizontal", "top", "bottom", "inner", "outer", and the like are orientation or position relationships based on the accompanying drawings. This is merely intended to facilitate and simplify the descriptions of this application, but is not intended to indicate or imply that an indicated apparatus or element needs to have a specific orientation or be constructed and operated in a specific orientation. Therefore, such terms cannot be construed as a limitation on this application.

In addition, the terms "first" and "second" are merely intended for a purpose of description, and shall not be understood as an indication or implication of relative importance or implicit indication of a quantity of indicated technical features. Therefore, a feature limited by "first" or "second" may explicitly or implicitly include one or more features. In the descriptions of this application, "a plurality of" means two or more, unless otherwise explicitly and specifically defined.

The term "and/or" in embodiments of this application describes only an association relationship for describing associated objects and represents that three relationships may exist. For example, A and/or B may represent the following three cases: Only A exists, both A and B exist, and only B exists. In addition, the character "/" in this specification generally indicates an "or" relationship between the associated objects.

Reference to "an embodiment", "some embodiments", or the like described in this specification means that one or more embodiments of this application include a specific feature, structure, or characteristic described with reference to embodiments. Therefore, statements such as "in an embodiment", "in some embodiments", "in some other embodiments", and "in other embodiments" that appear at different places in this specification do not necessarily mean referring to a same embodiment. Instead, the statements mean "one or more but not all of embodiments", unless otherwise specifically emphasized in another manner. The terms "include", "have", and their variants all mean "include but are not limited to", unless otherwise specifically emphasized in another manner.

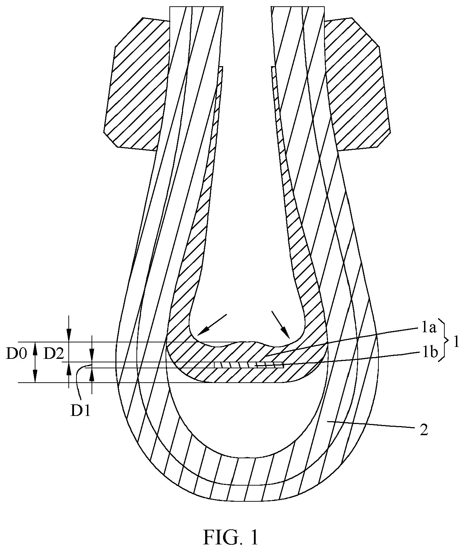

Refer to FIG. 1. An embodiment of this application provides an edge protection assembly, which may be applied to a foldable device. The edge protection assembly has a shielding member 1, and the shielding member 1 can shield and protect an edge of a bending region of a flexible display 2. The shielding member 1 may use an integrated injection-molded structure in which soft adhesive 1a wraps a steel sheet 1b, and the soft adhesive 1a is disposed on both an upper side and a lower side of the steel sheet 1b.

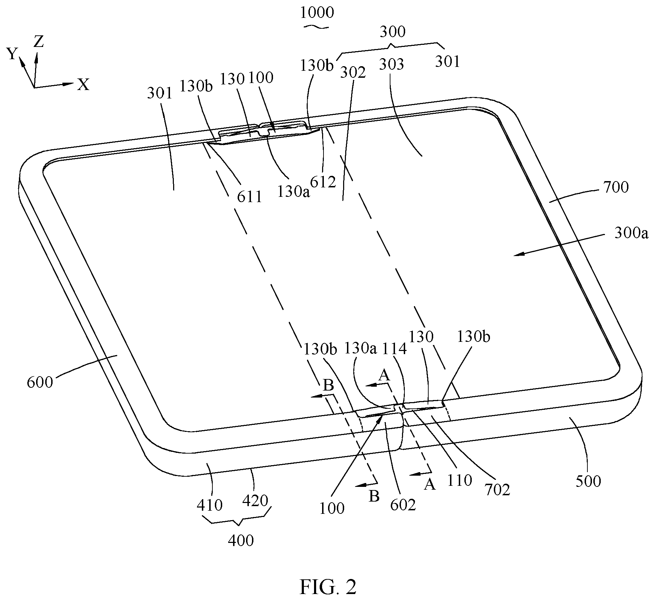

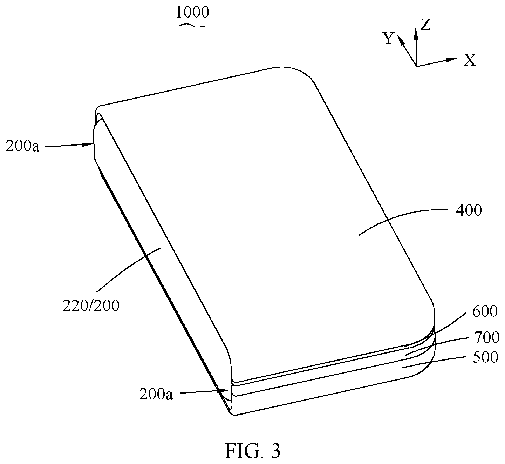

Refer to FIG. 2 and FIG. 3. To facilitate description of positions and directions of a foldable device 1000 and an edge protection assembly 100 in embodiments of this application, an arrangement direction of a first main body 400 and a second main body 500 of the foldable device 1000 in an unfolded state is defined as an X direction, a width direction of the foldable device 1000 or an axial direction of a hinge assembly 200 is defined as a Y direction, a thickness direction of the foldable device 1000 is defined as a Z direction, a thickness direction of a flexible display 300 in an unfolded state is also defined as the Z direction, and the X direction, the Y direction, and the Z direction are perpendicular to each other.

Refer to FIG. 2 and FIG. 3. An embodiment of this application provides the foldable device 1000, which may be a mobile phone, a tablet computer, a notebook computer, an e-book reader, a netbook, a personal digital assistant, an intelligent wearable device (such as a smartwatch), or the like.

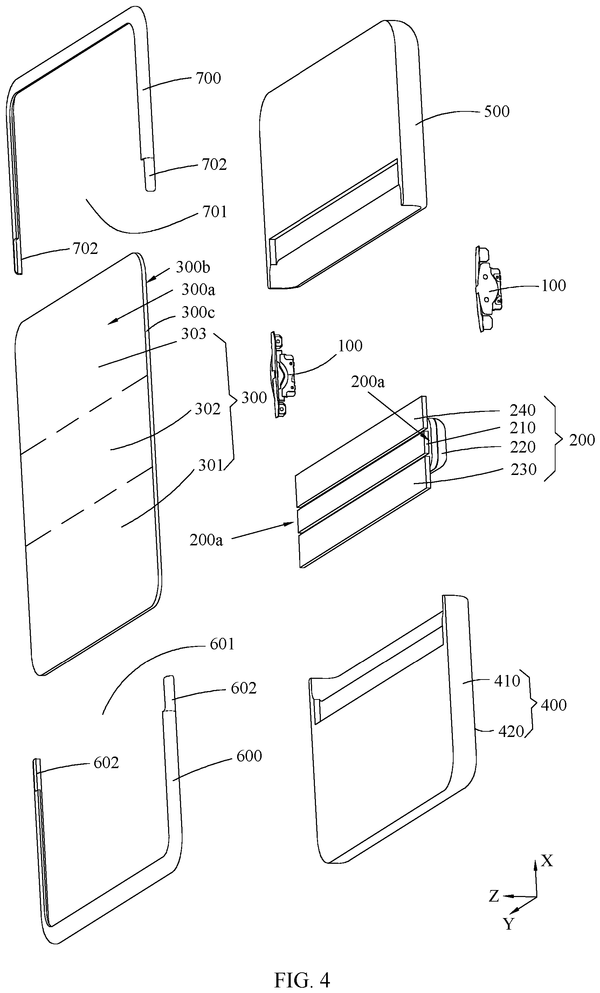

With reference to FIG. 4, an embodiment of this application provides the foldable device 1000, including the hinge assembly 200, the first main body 400, the second main body 500, the flexible display 300, and the edge protection assembly 100. The hinge assembly 200 is located between the first main body 400 and the second main body 500, and the first main body 400 and the second main body 500 are connected through the hinge assembly 200. The flexible display 300 has a display surface 300a and a back surface 300b that face away from each other. The back surface 300b of the flexible display 300 is fastened to the first main body 400 and the second main body 500. One end of the first main body 400 and one end of the second main body 500 may rotate relative to the hinge assembly 200, and one end that is of the first main body 400 and that faces away from the hinge assembly 200 and one end that is of the second main body 500 and that faces away from the hinge assembly 200 may move toward or away from each other. The flexible display 300 may be bent or unfolded as positions of the first main body 400 and the second main body 500 change, so that the foldable device 1000 switches between an unfolded state, an intermediate state, and a folded state.

Refer to FIG. 2. When the foldable device 1000 is in the unfolded state, the first main body 400 and the second main body 500 are respectively arranged on two sides of the hinge assembly 200 and are unfolded, an included angle between the first main body 400 and the second main body 500 is approximately 180°, and the flexible display 300 is unfolded and supported on the first main body 400, the hinge assembly 200, and the second main body 500.

Refer to FIG. 3. When the foldable device 1000 is in the folded state, the first main body 400 and the second main body 500 are folded to form a stacked structure, and the flexible display 300 is bent along with the first main body 400 and the second main body 500. The intermediate state of the foldable device 1000 is a state between the unfolded state and the folded state.

The foldable device 1000 may be configured as being of an inwardly folding structure. When the hinge assembly 200 is in the folded state, display accommodating space is formed between the first main body 400, the hinge assembly 200, and the second main body 500, the flexible display 300 is partially bent, and the flexible display 300 is located in the display accommodating space. A bent form of the flexible display 300 is affected by the hinge assembly 200. When the hinge assembly 200 is in the folded state, a cross section of the flexible display 300 in the bent form may be a water drop-shaped curved surface or a U-shaped curved surface.

The flexible display 300 is configured to display an image and information. The flexible display 300 may be an organic light-emitting diode display, an active-matrix organic light-emitting diode display, a mini light-emitting diode display, a micro light-emitting diode display, a micro organic light-emitting diode display, a quantum dot light-emitting diode display, or the like. A touch layer may be disposed in the flexible display 300 to implement a touch function.

Refer to FIG. 2 and FIG. 4. The flexible display 300 has a first fastening region 301, a bending region 302, and a second fastening region 303 that are sequentially connected. The first fastening region 301 is fastened to the first main body 400, the second fastening region 303 is fastened to the second main body 500, and the bending region 302 and the hinge assembly 200 are correspondingly disposed. The first fastening region 301 and the first main body 400, and the second fastening region 303 and the second main body 500 may be connected through adhesive bonding or in another manner.

During disposing of the hinge assembly 200, as shown in FIG. 4, the hinge assembly 200 may include a hinge body 210, a hinge housing 220, a first plate body 230, and a second plate body 240. Both the hinge body 210 and the hinge housing 220 extend in the Y direction. The hinge body 210 is disposed close to the flexible display 300, and the hinge housing 220 is disposed on a side that is of the hinge body 210 and that faces away from the flexible display 300. The first plate body 230 and the second plate body 240 are respectively connected to two sides of the hinge body 210 in the X direction, and can rotate relative to the hinge body 210. The first plate body 230 and the second plate body 240 may be fastened to the first main body 400 and the second main body 500 in a one-to-one correspondence through a fastener or in another manner, so that the first main body 400 and the second main body 500 can rotate relative to the hinge body 210.

During disposing of the first main body 400 and the second main body 500, as shown in FIG. 2, both the first main body 400 and the second main body 500 may include a middle housing 410 and a rear housing 420. The middle housing 410 may be referred to as a middle frame. The rear housing 420 is disposed on a side that is of the middle housing 410 and that faces away from the flexible display 300. The middle housing 410 and the rear housing 420 may be of an assembly structure, for example, the middle housing 410 is fastened to the middle housing 410 in a manner of bonding, snap-fitting, or the like. The middle housing 410 and the rear housing 420 may alternatively be of an integrally formed structure. Components such as a circuit board, a battery, a receiver, a speaker, a camera, and an antenna may be installed on the first main body 400 and the second main body 500. Components such as a processor and a storage unit may be disposed on the circuit board.

In some embodiments, as shown in FIG. 2, FIG. 4, and FIG. 5, a first side frame 600 is disposed on the first main body 400, and the first side frame 600 is disposed on an edge that is of the flexible display 300 and that corresponds to the first main body 400, to shield and protect the edge of the flexible display 300. A second side frame 700 is disposed on the second main body 500, and the second side frame 700 is disposed on an edge that is of the flexible display 300 and that corresponds to the second main body 500. The first side frame 600 may shield and protect an edge of the first fastening region 301 of the flexible display 300, and the second side frame 700 may shield and protect an edge of the second fastening region 303 of the flexible display 300, to prevent the edge of the flexible display 300 from being damaged and improve appearance effect.

The first main body 400 and the first side frame 600 may be of an assembly structure. For example, the first side frame 600 is fastened to the first main body 400 in a manner of bonding, snap-fitting, or the like. The first main body 400 and the first side frame 600 may alternatively be of an integrally formed structure. The second main body 500 and the second side frame 700 may be of an assembly structure. For example, the second side frame 700 is fastened to the second main body 500 in a manner of bonding, snap-fitting, or the like. The second main body 500 and the second side frame 700 may alternatively be of an integrally formed structure.

Forms of the first main body 400 and the second main body 500, and forms of the first side frame 600 and the second side frame 700 may be set based on a shape of the flexible display 300. For example, as shown in FIG. 4, the flexible display 300 in the unfolded state is approximately in a shape of a rounded rectangle, and the first main body 400 and the second main body 500 are approximately in a shape of a plate-shaped rectangle. Both the first side frame 600 and the second side frame 700 approximately extend in a right-angled U-shape, and cross sections of the first side frame 600 and the second side frame 700 in a direction perpendicular to extension directions of the first side frame 600 and the second side frame 700 may be approximately L-shaped or in another shape. An opening 601 of the first side frame 600 and an opening 701 of the second side frame 700 are provided facing each other. The first side frame 600 and the second side frame 700 are respectively disposed corresponding to different edges of the flexible display 300, to implement shielding and protection at positions of corresponding edges of the flexible display 300. In addition, the first main body 400 and the second main body 500, and the first side frame 600 and the second side frame 700 may be disposed in other forms based on the flexible display 300.

Refer to FIG. 2 and FIG. 5 to FIG. 7. An edge of the bending region 302 of the flexible display 300 is bent. The edge protection assembly 100 may be disposed between the first side frame 600 and the second side frame 700, that is, may be disposed on the hinge assembly 200, to shield and protect the edge of the bending region 302 of the flexible display 300, thereby preventing external foreign objects such as dust and water from entering the flexible display 300, and improving aesthetics of a position of the edge of the bending region 302 of the flexible display 300. One edge protection assembly 100 may be disposed on each of two end portions 200a of the hinge assembly 200, to shield and protect edges, of the bending region 302 of the flexible display 300, corresponding to the two end portions 200a of the hinge assembly 200.

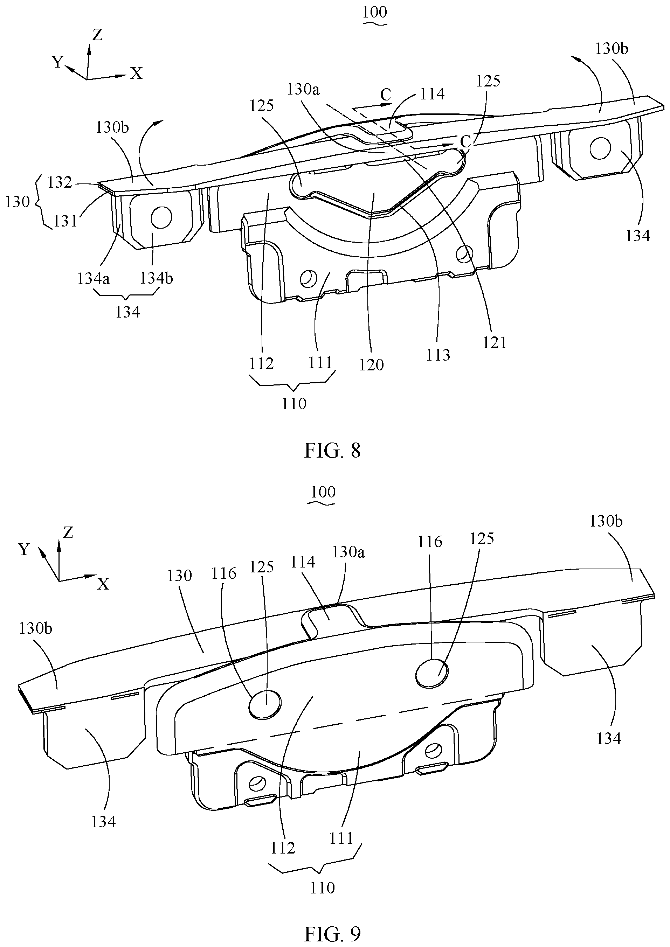

Refer to FIG. 8 to FIG. 11. The edge protection assembly 100 provided in embodiments of this application is applied to the foldable device 1000 having the hinge assembly 200 and the flexible display 300. The edge protection assembly 100 includes a fastening member 110, a supporting member 120, and a flexible embedded member 130. The fastening member 110 is configured to be fastened to the hinge assembly 200. In an axial direction (Y direction) of the hinge assembly 200, a projection of the fastening member 110 covers a part of a side surface 300c of the flexible display 300. The supporting member 120 is fastened to the fastening member 110. In the thickness direction (Z direction) of the flexible display 300, a projection of the flexible embedded member 130 covers the edge of the bending region 302 of the display surface 300a of the flexible display 300. A middle part 130a of the flexible embedded member 130 in the length direction (X direction) is connected to the supporting member 120. The flexible embedded member 130 includes an elastic sheet 131 and a flexible body 132, where the elastic sheet 131 is embedded in the flexible body 132, and the elastic sheet 131 and the flexible body 132 are of an integrally formed structure. A length direction of the flexible embedded member 130 is the X direction, and the length direction (X direction) of the flexible embedded member 130 is perpendicular to the axial direction (Y direction) of the hinge assembly 200.

Refer to FIG. 4, FIG. 6, and FIG. 11. The side surface 300c of the flexible display 300 is an outer circumferential surface connecting the display surface 300a and the back surface 300b.

The display surface 300a of the flexible display 300 is a light-emitting side of the flexible display 300, and the display surface 300a may include a display region and a non-display region located at an edge of the display region. In the thickness direction (Z direction) of the flexible display 300, the flexible embedded member 130 may block a part of an edge of the non-display region, and does not affect light-emitting display effect of the display region of the flexible display 300.

The middle part 130a of the flexible embedded member 130 in the length direction (X direction) may not be an exact middle position in the length direction, but a middle region of the flexible embedded member 130 in the length direction. Positions other than two ends 130b in the length direction of the flexible embedded member 130 may be understood as the middle part 130a in the length direction.

According to the edge protection assembly 100 provided in this embodiment of this application, the elastic sheet 131 is embedded in the flexible body 132, to integrally form the flexible embedded member 130, the flexible body 132 is prone to bending and deformation, and the elastic sheet 131 plays a reinforcement role. The fastening member 110 is fastened to the hinge assembly 200, the supporting member 120 is fastened to the fastening member 110, and the middle part 130a of the flexible embedded member 130 in the length direction (X direction) is connected to the supporting member 120. In a process in which the foldable device 1000 switches between the unfolded state and the folded state, the middle part 130a of the flexible embedded member 130 is fixed, and the two ends 130b move freely. The flexible embedded member 130 can keep covering the edge of the bending region 302 of the display surface 300a of the flexible display 300, to protect the edge of the bending region 302, thereby preventing external foreign objects such as dust and water from entering the flexible display 300, and improving aesthetics of a position of the edge of the bending region 302 of the flexible display 300. Under prolonged repeated bending, static bending, or high-temperature and high-humidity conditions, deformation of the flexible embedded member 130 is small, and the flexible embedded member 130 is not prone to creasing, arching, or detachment, and can be restored to a flat natural form when being in an unfolded state, so that user experience is good, reliability is high, and a folding life is long. The flexible embedded member 130 facilitates formation of a uniform bending form during bending of the flexible display 300, reduces mutual compression forces between the flexible embedded member 130 and the flexible display 300 in a folding process, and prevents the flexible display 300 from sustaining crack damage due to compression. Even if a bending radius of the flexible display 300 reaches 1.5 millimeters, the flexible display 300 is still not prone to crack damage due to compression from the flexible embedded member 130.

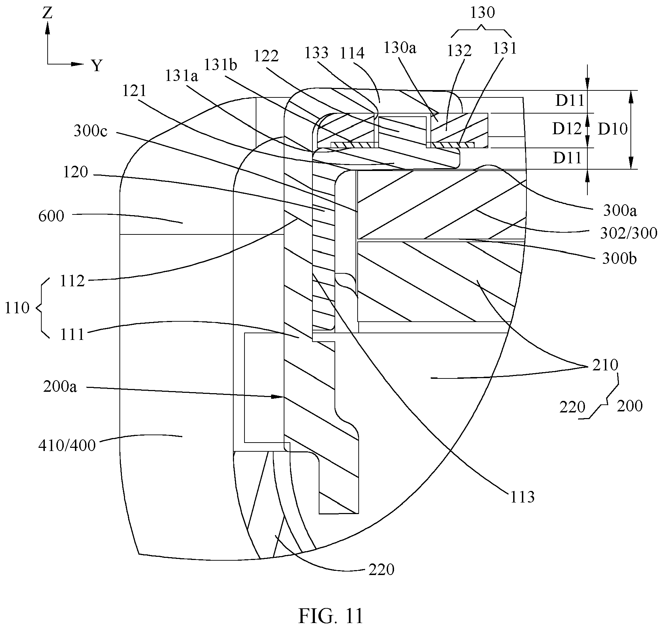

When the edge protection assembly 100 is applied to the foldable device 1000, refer to FIG. 2 and FIG. 11. FIG. 2 is a diagram of a structure of a foldable device in an unfolded state. FIG. 11 is a partial sectional view of the foldable device in FIG. 2 along a line A-A. The fastening member 110 is fastened to the hinge assembly 200, and the supporting member 120 is fastened to a side that is of the fastening member 110 and that faces the side surface 300c of the flexible display 300. This assembly manner occupies little space. A top of the fastening member 110 is used as an appearance surface, and the top of the fastening member 110 can be seen from the outside, but the supporting member 120 cannot be seen, so that the edge protection assembly 100 has good aesthetics. The edge protection assembly 100 is disposed close to the end portion 200a of the hinge assembly 200. The fastening member 110 may be fastened to the hinge assembly 200 through adhesive bonding, snap-fit connection, and a fastener (such as a screw), or in another manner.

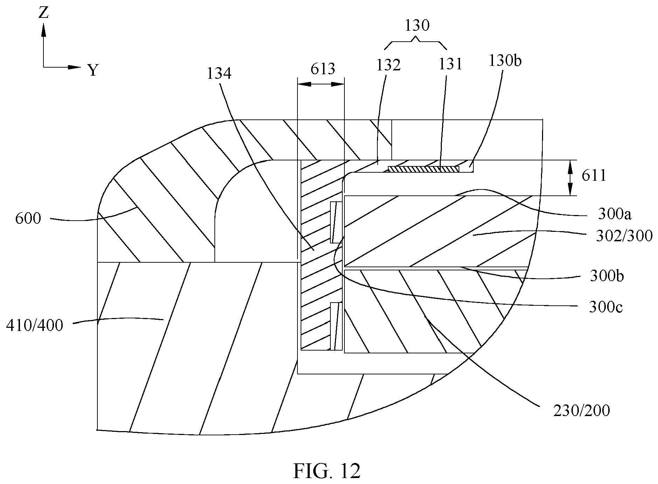

In a case in which the first side frame 600 is disposed on the first main body 400 and the second side frame 700 is disposed on the second main body 500, refer to FIG. 2 and FIG. 12. FIG. 12 is a partial sectional view of the foldable device in FIG. 2 along a line B-B. In the thickness direction (Z direction) of the flexible display 300, a first gap 611 is formed between the first side frame 600 and the display surface 300a of the flexible display 300, and a second gap 612 is formed between the second side frame 700 and the display surface 300a of the flexible display 300. One end 130b of the flexible embedded member 130 is located in the first gap 611, and the other end 130b of the flexible embedded member 130 is located in the second gap 612.

One end 130b of the flexible embedded member 130 is disposed between the first side frame 600 and the flexible display 300, and the other end 130b is disposed between the second side frame 700 and the flexible display 300, to limit the two ends of the flexible embedded member 130. The one end 130b of the flexible embedded member 130 may freely move relative to the first side frame 600 and the flexible display 300, and the other end 130b of the flexible embedded member 130 may freely move relative to the second side frame 700 and the flexible display 300, thereby preventing the flexible embedded member 130 from being detached from a predetermined position.

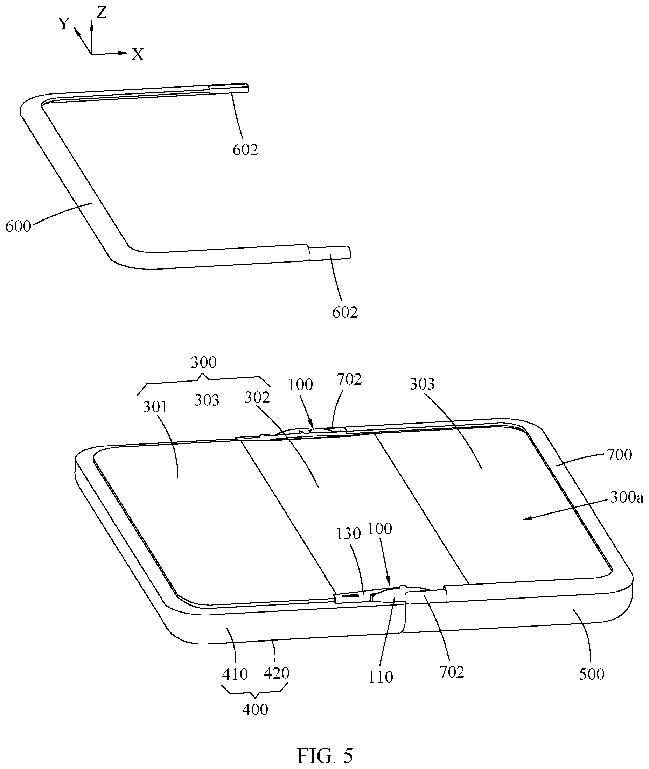

In some embodiments, as shown in FIG. 2, FIG. 4, and FIG. 5, there is a first shielding portion 602 at a position that is of the first side frame 600 and that is close to the hinge assembly 200, and there is a second shielding portion 702 at a position that is of the second side frame 700 and that is close to the hinge assembly 200. In the axial direction (Y direction) of the hinge assembly 200, a projection of the first shielding portion 602 partially covers the fastening member 110, and a projection of the second shielding portion 702 partially covers the fastening member 110, to protect the fastening member 110. FIG. 5 shows that after the first side frame 600 is detached from the foldable device, the fastening member 110 is not shielded by the first shielding portion 602, the second side frame 700 is mounted on the second main body 500, and a part of a surface of the fastening member 110 is shielded by the second shielding portion 702 of the second side frame 700.

In the axial direction (Y direction) of the hinge assembly 200, the first shielding portion 602 of the first side frame 600 and the second shielding portion 702 of the second side frame 700 can cover a part of a surface of a side that is of the fastening member 110 and that faces away from the flexible display 300. This protects the fastening member 110, prevents an external foreign object, such as a particle, from entering a gap between the fastening member 110 and the hinge assembly 200, improves reliability, and improves an appearance of the end portion 200a of the hinge assembly 200. The first shielding portion 602 and the second shielding portion 702 may be in a strip shape. When the foldable device 1000 is in the unfolded state, an end portion of the first shielding portion 602 and an end portion of the second shielding portion 702 are disposed opposite to each other.

During setting of materials of the fastening member 110 and the supporting member 120, as shown in FIG. 8 to FIG. 10, the material of the fastening member 110 may be metal or plastic. The material of the supporting member 120 may be metal or plastic. The fastening member 110 and the supporting member 120 are made of hard materials such as metal and plastic, to facilitate reliably connecting the fastening member 110 to the hinge assembly 200 and reliably connecting the supporting member 120 to the fastening member 110.

When the fastening member 110 and the supporting member 120 are made of a metal material, the fastening member 110 and the supporting member 120 have high strength, and can achieve good anti-collision effect. The metal material may be stainless steel, cast iron, aluminum alloy, magnesium alloy, or the like.

For example, the fastening member 110 and the supporting member 120 may be manufactured by using a metal injection process, have high dimensional precision and good structural strength, and can provide good protection effect for the edge of the flexible display 300. Alternatively, the fastening member 110 and the supporting member 120 may be manufactured by using a process such as die casting molding.

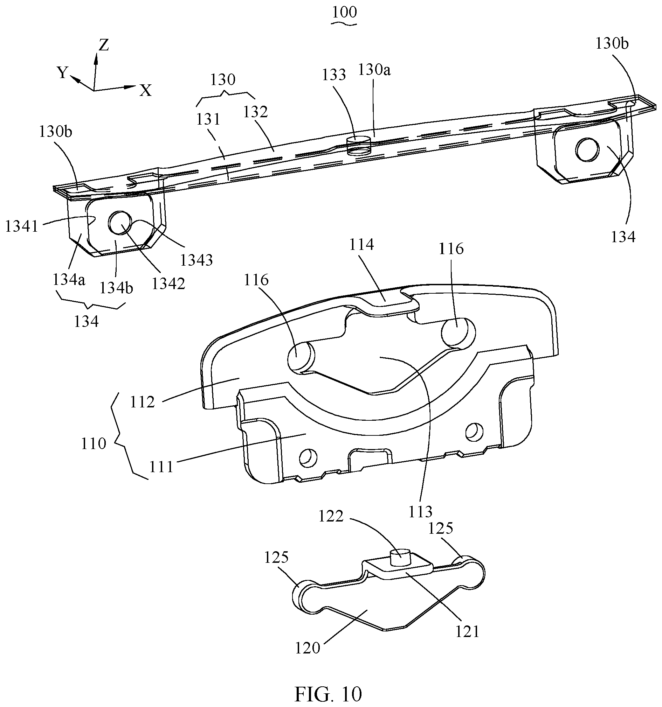

Refer to FIG. 10. The shapes of the fastening member 110 and the supporting member 120 may be set according to a requirement based on an appearance and a size of the flexible display 300 and an appearance and a size of the hinge assembly 200. For example, the supporting member 120 and the fastening member 110 may be approximately plate-shaped, and a thickness direction of the fastening member 110 and a thickness direction of the supporting member 120 are the axial direction (Y direction) of the hinge assembly 200. Alternatively, the supporting member 120 and the fastening member 110 may be in a block shape or another shape.

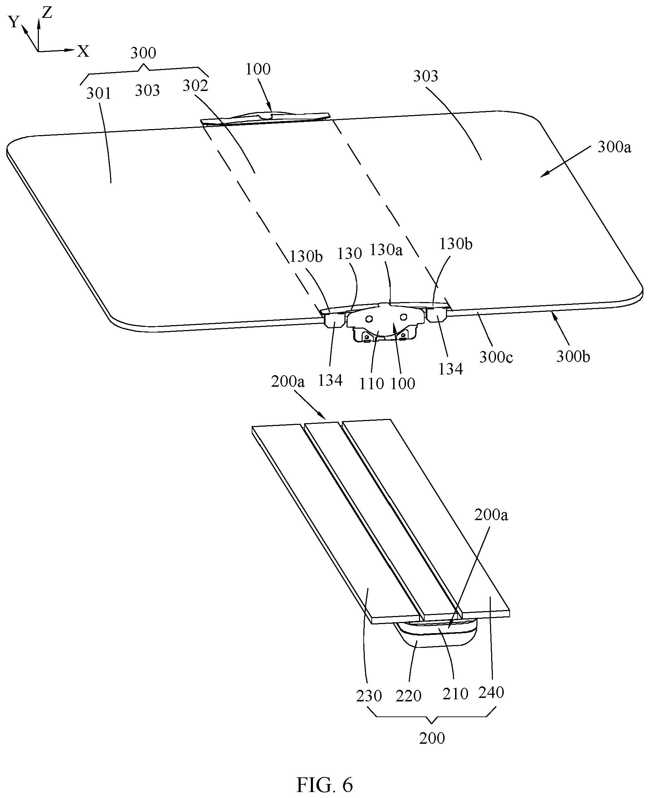

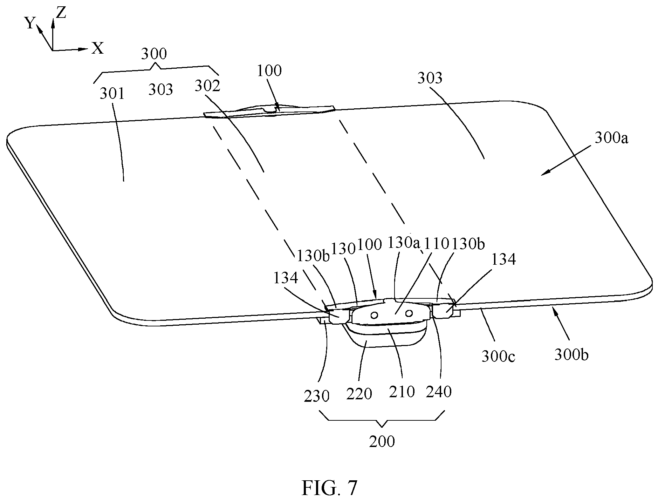

For example, as shown in FIG. 8 to FIG. 11, the fastening member 110 may include an insertion portion 111 and an assembling portion 112, where the insertion portion 111 is connected to the assembling portion 112. With reference to FIG. 6 and FIG. 7, the insertion portion 111 is configured to be inserted into the hinge assembly 200, and the assembling portion 112 is configured to be connected to the supporting member 120. A length of the insertion portion 111 in the X direction is less than a length of the assembling portion 112 in the X direction, the insertion portion 111 and the assembling portion 112 are approximately T-shaped, to facilitate inserting the insertion portion 111 into the hinge assembly 200, and two ends of the assembling portion 112 abut against a surface of the hinge assembly 200, thereby limiting the fastening member 110.

In some embodiments, as shown in FIG. 8, FIG. 10, and FIG. 11, there is a mounting groove 113 on a side that is of the fastening member 110 and that faces the flexible embedded member 130, and the supporting member 120 is embedded in the mounting groove 113, so that the supporting member 120 and the fastening member 110 occupy little space. The supporting member 120 is embedded in the mounting groove 113 of the fastening member 110, so that the supporting member 120 and the fastening member 110 occupy little space in the axial direction (Y direction) of the hinge assembly 200, to facilitate assembling the fastening member 110 on the hinge assembly 200 and having more space on the hinge assembly 200 for arranging other components.

For example, the elastic sheet 131 and the flexible body 132 in the flexible embedded member 130 are of an integrally formed structure. When the fastening member 110 is connected to the supporting member 120, the supporting member 120 is assembled on the fastening member 110, that is, the supporting member 120 and the fastening member 110 are combined, and the fastening member 110 is assembled on the hinge assembly 200. An assembling manner between the fastening member 110 and the supporting member 120 may be adhesive bonding, snap-fit connection, welding, or fastener (such as a screw) connection. A specific assembling manner is selected according to a requirement.

For example, the supporting member 120 is embedded in the mounting groove 113 of the fastening member 110, and the supporting member 120 is bonded to a bottom surface of the mounting groove 113 of the fastening member 110 through adhesive, so that the supporting member 120 is reliably fastened to the fastening member 110.

For example, both the supporting member 120 and the fastening member 110 are approximately plate-shaped, the supporting member 120 is embedded in the mounting groove 113 of the fastening member 110, and a snap fit 125 of the supporting member 120 is snap-fitted into a slot 116 of the fastening member 110, so that the supporting member 120 is reliably fastened to the fastening member 110. The slot 116 may penetrate the fastening member 110 or may not penetrate the fastening member 110. The snap fit 125 and the slot 116 are set to be in shapes that adapt to each other, so that the snap fit 125 is stably snap-fitted into the slot 116. For example, a cross section of the snap fit 125 is cylindrical, and a cross section of the slot 116 is cylindrical; or the snap fit 125 extends in an L shape, and a cross section of the slot 116 is rectangular. A plurality of groups of snap fits 125 and slots 116 may be disposed, to implement reliable connection between the supporting member 120 and the fastening member 110.

For example, both the supporting member 120 and the fastening member 110 are approximately plate-shaped, and the supporting member 120 is welded to the fastening member 110, so that the supporting member 120 is reliably fastened to the fastening member 110.

For example, both the supporting member 120 and the fastening member 110 are approximately plate-shaped, and a fastener penetrates the supporting member 120 and is in threaded connection to the fastening member 110, so that the supporting member 120 is reliably fastened to the fastening member 110.

A shape of the flexible embedded member 130 may be set according to a requirement based on an appearance and a size of the flexible display 300. For example, as shown in FIG. 8 to FIG. 10, the flexible embedded member 130 may be approximately set to be of a long strip structure. Both the elastic sheet 131 and the flexible body 132 in the flexible embedded member 130 may extend along the edge of the bending region 302 of the flexible display 300, so that the elastic sheet 131 is closely connected to the flexible body 132, to shield and protect a part of the side surface 300c of the flexible display 300 and the edge of the bending region 302 of the display surface 300a. The flexible embedded member 130 may be of a long strip structure that is straight, partially curved, or with a specific radian. In addition, the elastic sheet 131 and the flexible body 132 may alternatively be set to be in other shapes.

During setting of relative positions of the elastic sheet 131 and the flexible body 132, as shown in FIG. 10, FIG. 11, FIG. 13, and FIG. 14, the elastic sheet 131 has a first surface 131a and a second surface 131b that face away from each other, the first surface 131a and the edge of the bending region 302 of the display surface 300a of the flexible display 300 are disposed facing each other, and the flexible body 132 is disposed on the second surface 131b.

In this embodiment, in the thickness direction (Z direction) of the flexible display 300, the flexible body 132 covers the elastic sheet 131, and the elastic sheet 131 covers the edge of the bending region 302 of the display surface 300a of the flexible display 300. The flexible embedded member 130 with a small thickness may be obtained by using an integral forming process. For example, a thickness of the flexible embedded member 130 is approximately 0.1 millimeters. This facilitates thinning of the entire foldable device 1000. A part of the flexible body 132 is used as an appearance surface, and a top of the flexible body 132 can be seen from the outside, but the elastic sheet 131 cannot be seen, so that the flexible embedded member 130 has good aesthetics.

During manufacturing of the elastic sheet 131 and the flexible body 132, as shown in FIG. 8 to FIG. 10, the elastic sheet 131 may be a plastic sheet or a metal sheet, a material of the flexible body 132 may be soft adhesive, and the elastic sheet 131 and the flexible body 132 are of an insert injection-molded structure.

The elastic sheet 131 and the flexible body 132 are of an insert injection-molded structure. Insert injection molding is to fasten an insert to a predetermined position in a mold in advance, and then inject plastic for molding. After the mold is opened, the insert is wrapped in cooled and cured plastic in a product. The flexible body 132 is easily injection-molded, and the elastic sheet 131 has specific rigidity and strength. The elastic sheet 131 is used as the insert, and injection molding is performed to obtain the flexible body 132 that wraps the elastic sheet 131. The elastic sheet 131 and the flexible body 132 are combined to complement each other, and are connected stably, to form the integrated flexible embedded member 130. In this way, an overall thickness and a weight are small, reliability is high, and the flexible embedded member 130 is not prone to creasing, arching, and detachment upon prolonged repeated bending and use in high-temperature and high-humidity conditions.

The elastic sheet 131 may be a plastic sheet, for example, a polyethylene terephthalate (polyethylene terephthalate, PET) sheet or a polyimide (polyimide, PI) sheet. The elastic sheet 131 may alternatively be a metal sheet, for example, a steel sheet.

The material of the flexible body 132 may be soft adhesive that is high-temperature-resistant and high-humidity-resistant, for example, silica gel, thermoplastic elastomer (thermoplastic elastomer, TPE), thermoplastic urethane (thermoplastic urethane, TPU), polyvinyl chloride (polyvinyl chloride, PVC) soft adhesive, rubber (such as silicone rubber, natural rubber, butadiene rubber, styrene-butadiene rubber, ethylene propylene rubber), or another material.

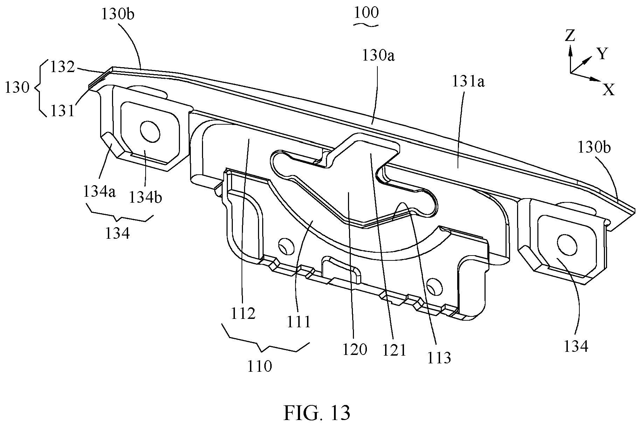

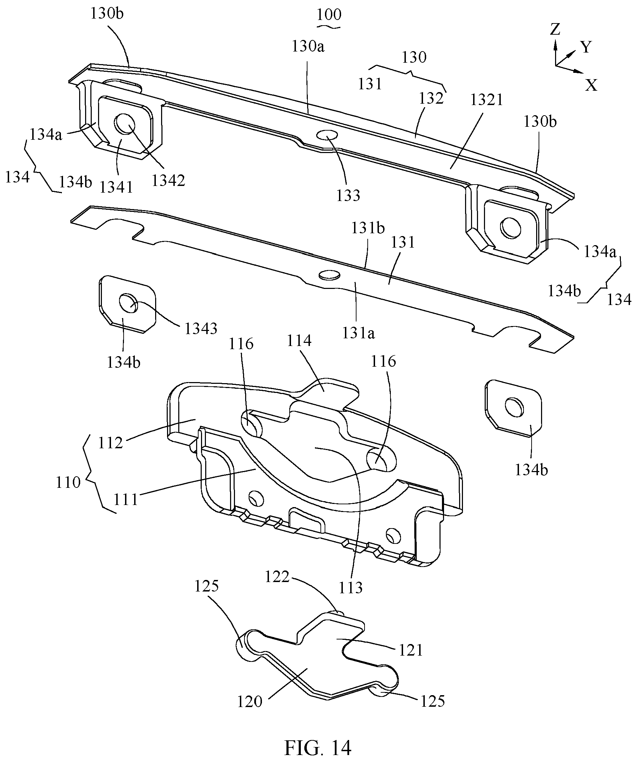

For example, as shown in FIG. 13 and FIG. 14, there is a first groove 1321 on a side that is of the flexible body 132 and that faces the display surface 300a of the flexible display 300, and the elastic sheet 131 is embedded in the first groove 1321, so that the flexible body 132 is used as an appearance member, and the flexible body 132 wraps a surface of the elastic sheet 131, thereby increasing a connection area between the flexible body 132 and the elastic sheet 131. In this way, the flexible body 132 and the elastic sheet 131 are reliably connected. An embodiment of this application provides the edge protection assembly 100, as shown in FIG. 8, FIG. 10, and FIG. 11, the fastening member 110 has a protruding first positioning portion 114, the supporting member 120 has a protruding second positioning portion 121, and the first positioning portion 114 and the second positioning portion 121 clamp the middle part 130a of the flexible embedded member 130.

The edge protection assembly 100 in this embodiment may be understood as an assembling solution of three parts: the fastening member 110 having the first positioning portion 114, the supporting member 120 having the second positioning portion 121, and the flexible embedded member 130. Both the first positioning portion 114 of the fastening member 110 and the second positioning portion 121 of the supporting member 120 may extend in the Y direction. The first positioning portion 114 of the fastening member 110 and the second positioning portion 121 of the supporting member 120 are used to clamp the middle part 130a of the flexible embedded member 130, the fastening member 110 is fastened to the hinge assembly 200, and the supporting member 120 is assembled on and fastened to the fastening member 110, so that the middle part 130a of the flexible embedded member 130 is rigidly fixed (fixed in the Z direction), and the two ends 130b are soft and move freely.

In a process in which the foldable device 1000 switches between the unfolded state and the folded state, as shown in FIG. 2 and FIG. 8, the middle part 130a of the flexible embedded member 130 is kept on the supporting member 120, the two ends 130b of the flexible embedded member 130 move freely along with the first main body 400 and the second main body 500, and the flexible embedded member 130 may be bent around the middle part 130a of the flexible embedded member 130. FIG. 8 shows that the two ends 130b of the flexible embedded member 130 may move along an arrow direction. When an included angle between the first main body 400 and the second main body 500 varies, the flexible embedded member 130 can always cover the edge of the bending region 302 of the display surface 300a of the flexible display 300, to shield and protect the edge of the bending region 302 of the flexible display 300.

In the embodiment shown in FIG. 1, the shielding member 1 uses an integrated injection-molded structure in which the soft adhesive 1a wraps the steel sheet 1b, the soft adhesive 1a is disposed on both the upper side and the lower side of the steel sheet 1b, and a total thickness D0 of the shielding member 1 is a sum of twice a thickness D2 of one layer of soft adhesive 1a and a thickness D1 of one layer of steel sheet 1b. The thickness D2 of one layer of soft adhesive 1a manufactured by using a related process is much greater than the thickness D1 of one layer of steel sheet 1b (or plastic sheet), so that the overall thickness D0 of the shielding member 1 shown in FIG. 1 is large.

In the embodiment shown in FIG. 8 to FIG. 11, the first positioning portion 114 and the second positioning portion 121 are sheet-like bodies made of metal or plastic, and the first positioning portion 114 and the second positioning portion 121 clamp the flexible embedded member 130 in the thickness direction (Z direction) of the flexible embedded member 130. A thickness D11 of the first positioning portion 114 or the second positioning portion 121 in the embodiment shown in FIG. 8 to FIG. 11 may be equivalent to the thickness D1 of one layer of steel sheet in the shielding member shown in FIG. 1, and a thickness D12 of the flexible embedded member 130 (an integrally formed structure of the flexible body 132 and the elastic sheet 131) in the embodiment shown in FIG. 8 to FIG. 11 may be equivalent to the thickness D2 of one layer of soft adhesive in the shielding member in the embodiment shown in FIG. 1. The embodiment shown in FIG. 8 to FIG. 11 are different from the shielding member 1 shown in FIG. 1 in that, one layer of thick soft adhesive is reduced, and the elastic sheet 131 (a metal sheet or a plastic sheet) is embedded in the flexible body 132. In this embodiment, a total thickness D10 of the first positioning portion 114, the second positioning portion 121, and the flexible embedded member 130 clamped by the first positioning portion 114 and the second positioning portion 121 is smaller, which helps reduce an overall thickness at a position, of the foldable device 1000, corresponding to the middle part 130a of the flexible embedded member 130.

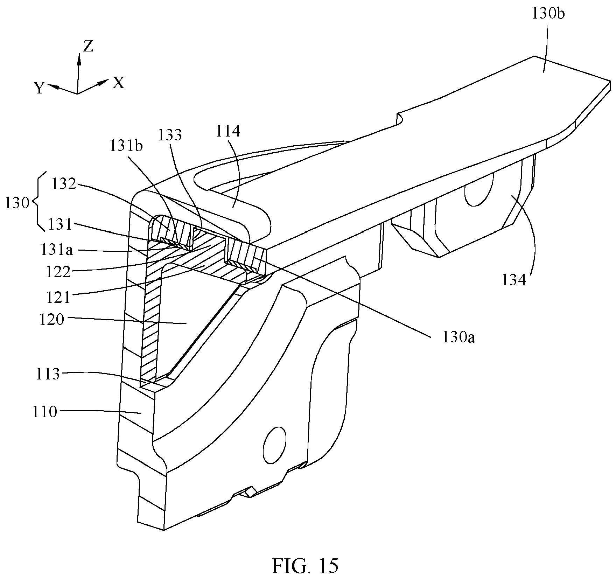

In some embodiments, as shown in FIG. 8, FIG. 10, FIG. 11, and FIG. 15, on a basis that the first positioning portion 114 of the fastening member 110 and the second positioning portion 121 of the supporting member 120 clamp the middle part 130a of the flexible embedded member 130, a third positioning portion 122 is disposed between the first positioning portion 114 and the second positioning portion 121, the middle part 130a of the flexible embedded member 130 in the length direction has a positioning hole 133, and the third positioning portion 122 penetrates the positioning hole 133, so that the middle part 130a of the flexible embedded member 130 is reliably fastened to the supporting member 120.

The third positioning portion 122 between the first positioning portion 114 and the second positioning portion 121 penetrates the positioning hole 133 of the middle part 130a of the flexible embedded member 130, so that the middle part 130a of the flexible embedded member 130 is reliably fastened to the supporting member 120. Under prolonged repeated bending, static bending, or high-temperature and high-humidity conditions, the flexible embedded member 130 is not prone to problems of creasing, arching, and detachment, and reliability is high. The positioning hole 133 may penetrate the flexible embedded member 130 or may not penetrate the flexible embedded member 130.

For example, the positioning hole 133 of the flexible embedded member 130 may be holes respectively provided at corresponding positions of the elastic sheet 131 and the flexible body 132.

For example, the third positioning portion 122 may be in a columnar shape, a block shape, or another shape, and the third positioning portion 122 may pass through the positioning hole 133 of the flexible embedded member 130.

In some embodiments, as shown in FIG. 8, FIG. 10, FIG. 11, and FIG. 15, the third positioning portion 122 is disposed on a side that is of the second positioning portion 121 and that faces the first positioning portion 114, and an end that is of the third positioning portion 122 and that faces away from the second positioning portion 121 is connected to or in contact with the first positioning portion 114, to facilitate the supporting member 120 and the fastening member 110 to clamp the flexible embedded member 130.

The third positioning portion 122 is disposed on the side that is of the second positioning portion 121 and that faces the first positioning portion 114, so that the third positioning portion 122 is connected to or in contact with the first positioning portion 114. This facilitates molding and assembling of the fastening member 110 having the first positioning portion 114 and the supporting member 120 having the second positioning portion 121 and the third positioning portion 122. The first positioning portion 114 and the second positioning portion 121 clamp the flexible embedded member 130, and the third positioning portion 122 between the first positioning portion 114 and the second positioning portion 121 penetrates the positioning hole 133 of the middle part 130a of the flexible embedded member 130, so that the middle part 130a of the flexible embedded member 130 is reliably fastened to the supporting member 120.

For example, the fastening member 110 having the first positioning portion 114 and the supporting member 120 having the second positioning portion 121 and the third positioning portion 122 are both metal members. The third positioning portion 122 on the second positioning portion 121 of the supporting member 120 penetrates the positioning hole 133 of the middle part 130a of the flexible embedded member 130, and an end portion of the third positioning portion 122 is welded to the first positioning portion 114 of the fastening member 110, so that the supporting member 120 is reliably fastened to the fastening member 110. The first positioning portion 114 and the second positioning portion 121 jointly clamp the flexible embedded member 130, so that the middle part 130a of the flexible embedded member 130 is reliably fastened to the supporting member 120.

In some other embodiments, the third positioning portion 122 may be disposed on a side that is of the first positioning portion 114 and that faces the second positioning portion 121, and an end that is of the third positioning portion 122 and that faces away from the first positioning portion 114 is connected to or in contact with the second positioning portion 121. The first positioning portion 114 and the second positioning portion 121 clamp the flexible embedded member 130, and the third positioning portion 122 between the first positioning portion 114 and the second positioning portion 121 penetrates the positioning hole 133 of the middle part 130a of the flexible embedded member 130, so that the middle part 130a of the flexible embedded member 130 is reliably fastened to the supporting member 120.

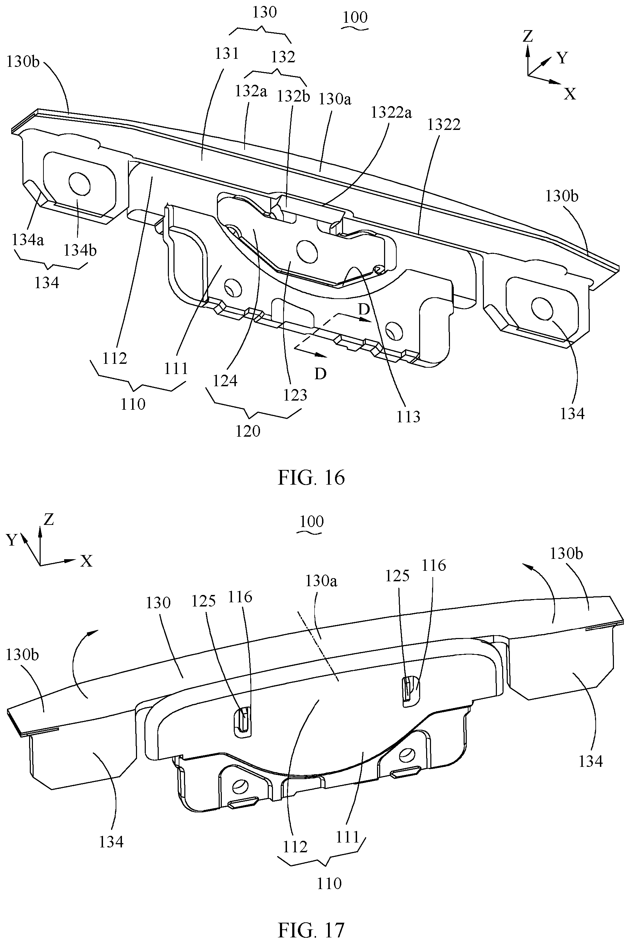

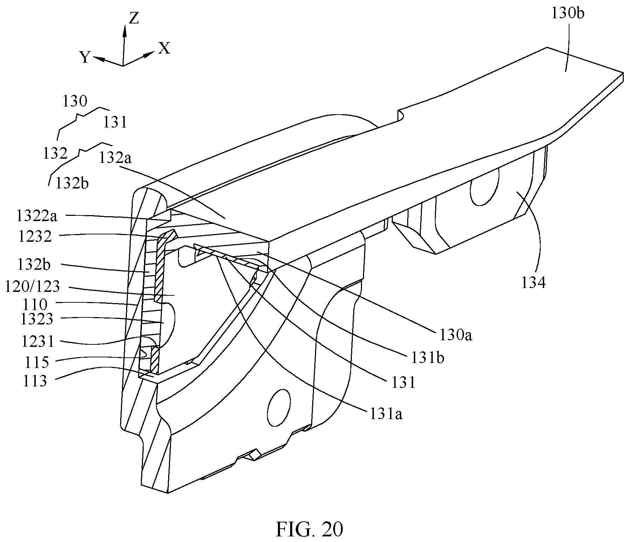

An embodiment of this application provides another edge protection assembly 100, as shown in FIG. 16 to FIG. 20, the flexible body 132 includes a strip portion 132a and a connecting portion 132b, the strip portion 132a is connected to the elastic sheet 131, the strip portion 132a has a first side surface 1322 facing the fastening member 110, and the connecting portion 132b is connected to a middle part 1322a of the first side surface 1322 of the strip portion 132a. The supporting member 120 is embedded in the connecting portion 132b, and the supporting member 120, the elastic sheet 131, and the flexible body 132 are of an integrally formed structure.

The first side surface 1322 may extend in the X direction. The middle part 1322a of the first side surface 1322 may not be an exact middle position in the length direction, but a middle region of the first side surface 1322 in the length direction. The middle part 1322a of the first side surface 1322 corresponds, in the Y direction, to the middle part 130a of the flexible embedded member 130 in the length direction (X direction).

The edge protection assembly 100 in this embodiment may be understood as an assembling solution of two parts: the fastening member 110 and the integrally formed structure, where the integrally formed structure includes the supporting member 120, the elastic sheet 131, and the flexible body 132. The integrally formed structure of the supporting member 120, the elastic sheet 131, and the flexible body 132 is used, and the middle part 1322a of the first side surface 1322 of the strip portion 132a in the flexible body 132 is connected to the connecting portion 132b. The supporting member 120 is embedded in the connecting portion 132b, to support the middle part 130a of the flexible embedded member 130. The fastening member 110 is fastened to the hinge assembly 200, the supporting member 120 is assembled on and fastened to the fastening member 110, and the flexible embedded member 130 is soft as a whole, so that the middle part 130a of the flexible embedded member 130 is flexibly fixed, and the two ends 130b are soft and move freely. The middle part 1322a of the first side surface 1322 of the flexible embedded member 130 is supported and fastened through the supporting member 120. In a process in which the foldable device 1000 switches between the unfolded state and the folded state, a region of the middle part 130a of the flexible embedded member 130 other than the first side surface 1322 can be deformed. In other words, the middle part 130a of the flexible embedded member 130 is flexibly fixed.

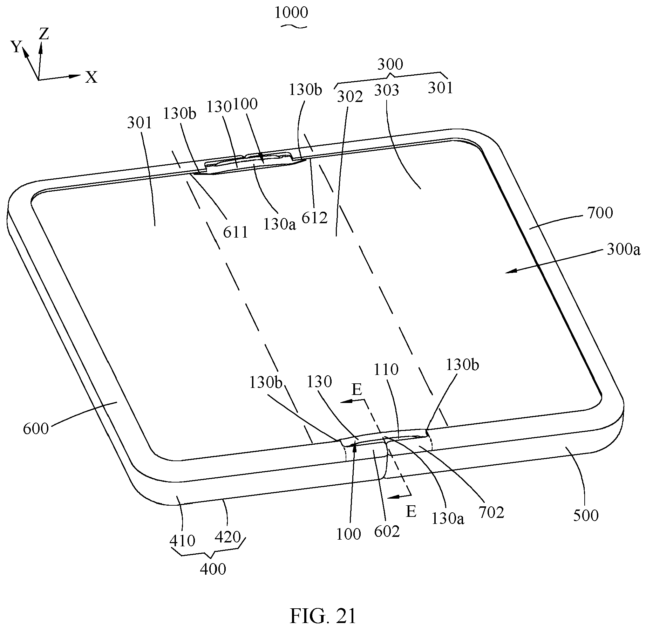

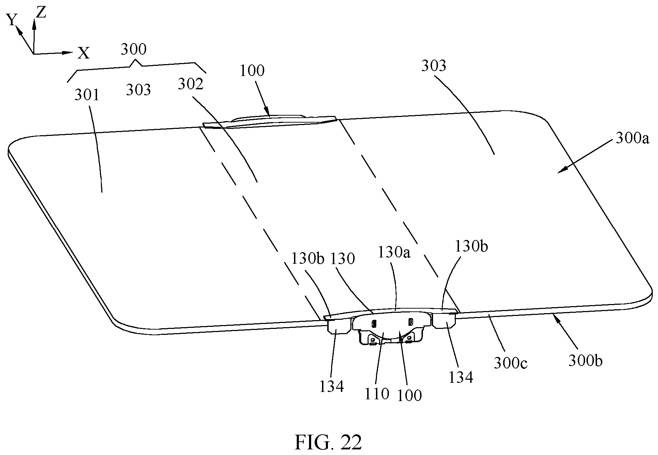

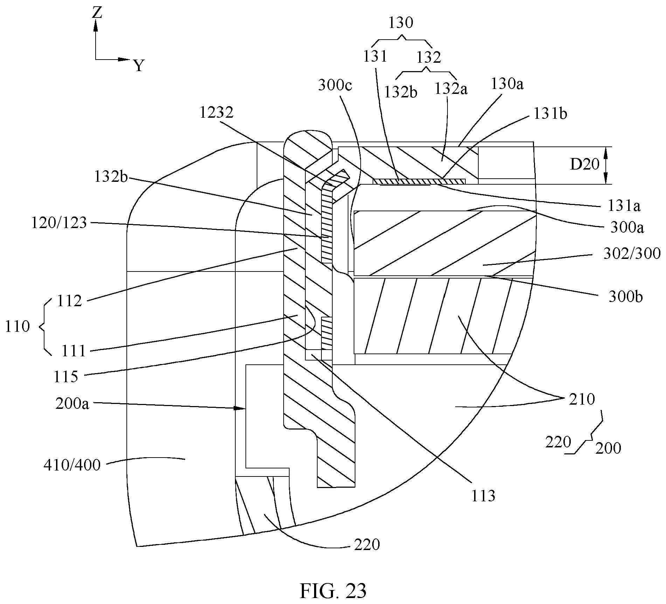

In a process in which the foldable device 1000 switches between the unfolded state and the folded state, with reference to FIG. 21 to FIG. 23, the middle part 130a of the flexible embedded member 130 is kept on the supporting member 120, the two ends 130b of the flexible embedded member 130 move freely along with the first main body 400 and the second main body 500, and the strip portion 132a of the flexible body 132 and the elastic sheet 131 may be bent around the connecting portion 132b. FIG. 17 shows that the two ends 130b of the flexible embedded member 130 may move along an arrow direction. When an included angle between the first main body 400 and the second main body 500 varies, the flexible embedded member 130 can always cover the edge of the bending region 302 of the display surface 300a of the flexible display 300, to shield and protect the edge of the bending region 302 of the flexible display 300.

In the embodiment shown in FIG. 16 to FIG. 20, the fastening member 110 does not have the protruding first positioning portion 114. In other words, a side that is of the flexible embedded member 130 and that faces away from the flexible display 300 does not have the first positioning portion 114, to improve aesthetics of the foldable device 1000. The supporting member 120 does not have the protruding second positioning portion 121, and a safe distance between the flexible embedded member 130 and the flexible display 300 may be small. Compared with the shielding member having two layers of soft adhesive and one layer of steel sheet in the embodiment shown in FIG. 1, the embodiment shown in FIG. 16 to FIG. 20 has only a thickness D20 of the flexible embedded member 130, which may be equivalent to the thickness D2 of one layer of soft adhesive in the embodiment shown in FIG. 1. The thickness D20 of the flexible embedded member 130 in the embodiment shown in FIG. 16 to FIG. 20 is very small, which helps reduce an overall thickness at a position, of the foldable device 1000, corresponding to the middle part 130a of the flexible embedded member 130.

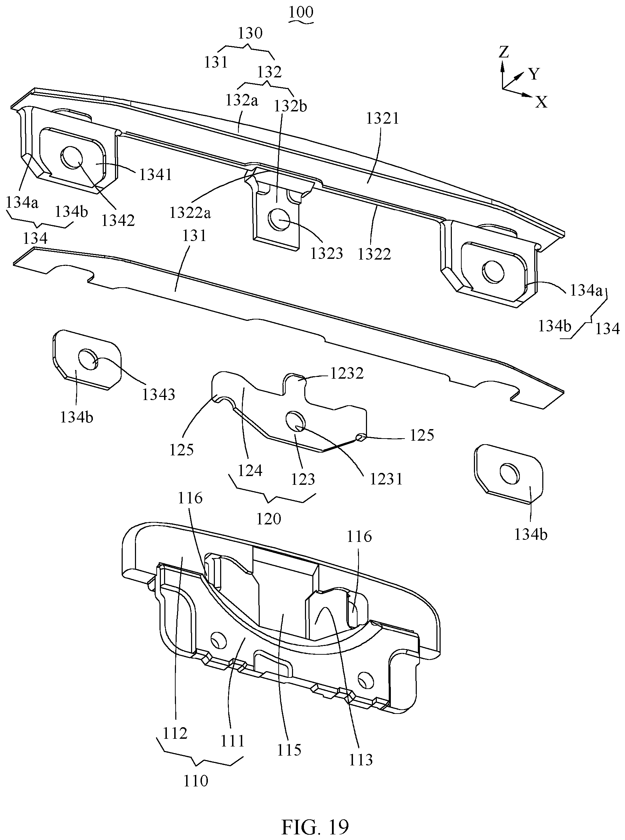

A shape of the connecting portion 132b may be set based on a shape of the fastening member 110. For example, as shown in FIG. 19, the fastening member 110 is approximately plate-shaped, and the connecting portion 132b may be plate-shaped, so that a thickness direction of the connecting portion 132b and the thickness direction of the fastening member 110 are the same, and are both disposed in the Y direction. In this way, a structure occupies little space in the Y direction, and the structure is compact. In addition, the connecting portion 132b may be in another shape.

In some embodiments, as shown in FIG. 16 to FIG. 19, the supporting member 120 includes a supporting portion 123 and an assembly portion 124 connected to the supporting portion 123, the supporting portion 123 is embedded in the connecting portion 132b, and the assembly portion 124 is connected to the fastening member 110, so that the supporting member 120, the connecting portion 132b, and the fastening member 110 are easily assembled. The assembly portion 124 in the supporting member 120 is assembled on the fastening member 110, so that the supporting member 120 and the fastening member 110 are combined, and the fastening member 110 is assembled on the hinge assembly 200.

The supporting member 120 is used as an insert, and the connecting portion 132b is injection-molded, so that the supporting member 120 is embedded in the connecting portion 132b, and the supporting member 120 and the connecting portion 132b are closely connected. The assembly portion 124 of the supporting member 120 is a part configured to connect to the fastening member 110. The assembly portion 124 and the fastening member 110 may be connected through a snap fit, adhesive bonding, welding, or a fastener (such as a screw), or in another manner.

For example, as shown in FIG. 17 to FIG. 19, the assembly portion 124 may be snap fits 125 disposed at two opposite ends of the supporting portion 123. The two snap fits 125 can be snap-fitted into two slots 116 of the fastening member 110, to fasten the supporting member 120 to the fastening member 110. The snap fit 125 and the slot 116 are set to be in shapes that adapt to each other, so that the snap fit 125 is stably snap-fitted into the slot 116. For example, the snap fit 125 extends in an L shape, and a cross section of the slot 116 is rectangular. The snap fit 125 may alternatively be welded to the fastening member 110, to improve reliability of connection between the supporting member 120 and the fastening member 110.

For example, the assembly portion 124 is embedded in the mounting groove 113 of the fastening member 110, and the assembly portion 124 is bonded to the bottom surface of the mounting groove 113 of the fastening member 110 through adhesive.

In some embodiments, as shown in FIG. 19, FIG. 20, and FIG. 23, the connecting portion 132b is located between the fastening member 110 and the supporting portion 123, there is an accommodating groove 115 on a side that is of the fastening member 110 and that faces the supporting member 120, and the connecting portion 132b is embedded in the accommodating groove 115, so that the connecting portion 132b occupies little space.

The connecting portion 132b is disposed in the accommodating groove 115 of the fastening member 110, and in the axial direction (Y direction) of the hinge assembly 200, the fastening member 110, the connecting portion 132b, and the supporting portion 123 of the supporting member 120 are arranged in sequence, so that the connecting portion 132b occupies little space, and a size of the edge protection assembly 100 in the axial direction of the hinge assembly 200 is small, to facilitate having more space on the hinge assembly 200 for assembling other components. When the fastening member 110 has the mounting groove 113, the mounting groove 113 may be provided on the bottom surface of the accommodating groove 115, and the accommodating groove 115 communicates with the mounting groove 113.

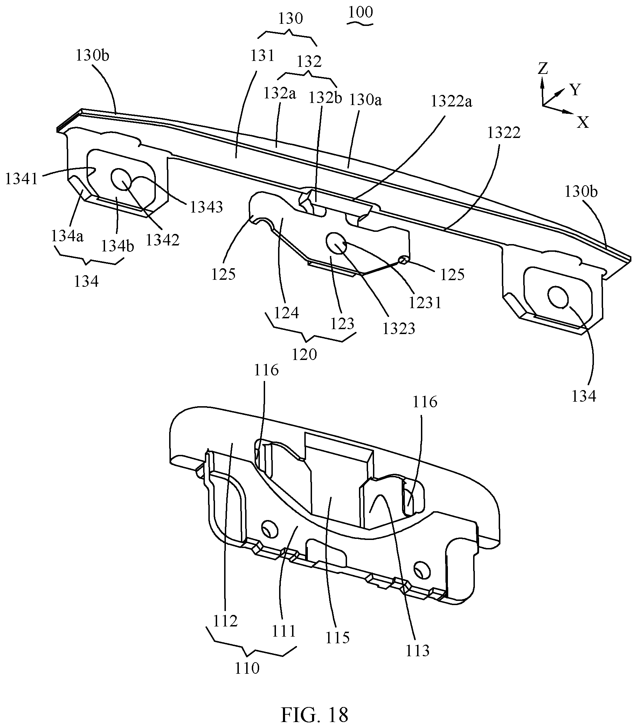

In some embodiments, as shown in FIG. 18 and FIG. 19, the supporting portion 123 has a first fitting hole 1231, the connecting portion 132b has a first fitting column 1323, the first fitting column 1323 is embedded in the first fitting hole 1231, and a wall surface of the first fitting hole 1231 is connected to an outer circumferential surface of the first fitting column 1323, to ensure reliable connection between the supporting portion 123 and the connecting portion 132b.

The supporting member 120 is used as an insert. In a process in which the connecting portion 132b is injection-molded, the first fitting hole 1231 of the supporting portion 123 is filled with a part of an injection molding material, and the injection molding material in the first fitting hole 1231 is cooled and cured to form the first fitting column 1323. The wall surface of the first fitting hole 1231 is connected to the outer circumferential surface of the first fitting column 1323, to increase a connection area between the connecting portion 132b and the supporting portion 123, so that the connecting portion 132b and the supporting portion 123 are closely connected.

In some embodiments, as shown in FIG. 19, FIG. 20, and FIG. 23, the supporting portion 123 has a bent section 1232 that bends and extends toward the strip portion 132a, and the bent section 1232 is embedded in a connection region between the connecting portion 132b and the strip portion 132a, to improve a support function of the supporting member 120 for the middle part 130a of the flexible embedded member 130 in the length direction.

A part of the supporting portion 123 is disposed as the bent section 1232, and the supporting member 120 is used as an insert, to facilitate the injection molding material flowing around the bent section 1232 and facilitate a region surrounding the bent section 1232 being fully filled with the injection molding material in a process in which the strip portion 132a and the connecting portion 132b are injection-molded. After the injection molding material is cooled and cured, the connection region between the connecting portion 132b and the strip portion 132a is formed, and the bent section 1232 can provide a good support function for the middle part 130a of the flexible embedded member 130 in the length direction. The bent section 1232 does not extend to the strip portion 132a, so that a region of the middle part 130a of the flexible embedded member 130 other than the first side surface 1322 can be deformed.

In some other embodiments, the bent section 1232 may not be disposed on the supporting portion 123, and the supporting portion 123 that vertically extends can still support the middle part 130a of the flexible embedded member 130 in the length direction.

In some embodiments, as shown in FIG. 8, FIG. 12, and FIG. 16, there is a limiting portion 134 at each of two ends of a side surface that is of the flexible embedded member 130 and that faces the fastening member 110, and the limiting portion 134 extends in the thickness direction (Z direction) of the flexible display 300, to prevent the flexible embedded member 130 from being easily detached from the edge of the flexible display 300. The two ends of the side surface that is of the flexible embedded member 130 and that faces the fastening member 110 are two ends of the side surface that is of the flexible embedded member 130 and that faces the fastening member 110 and extends in the X direction.

In the axial direction (Y direction) of the hinge assembly 200, a third gap 613 is formed between the first side frame 600 and the side surface 300c of the flexible display 300, and a fourth gap (not shown in the figure) is formed between the second side frame 700 and the side surface 300c of the flexible display 300. The limiting portion 134 at one end 130b of the flexible embedded member 130 is located in the third gap 613, and the limiting portion 134 at the other end 130b of the flexible embedded member 130 is located in the fourth gap. This manner is applicable to the foregoing plurality of implementations of the edge protection assembly 100.

In a process in which the foldable device 1000 switches between the unfolded state and the folded state, the middle part 130a of the flexible embedded member 130 is kept on the supporting member 120, and the limiting portion 134 of the flexible embedded member 130 is disposed in a gap between the first side frame 600 (the second side frame 700) and the side surface 300c of the flexible display 300, so that the two ends 130b of the flexible embedded member 130 move freely along with the first main body 400 and the second main body 500, and the flexible embedded member 130 is kept at the edge of the flexible display 300, and is not easily detached from the edge of the flexible display 300, to reliably shield and protect the edge of the flexible display 300, and prevent the flexible embedded member 130 from being detached under action of an external force. The limiting portion 134 may be set to be sheet-shaped, to facilitate assembling the limiting portion 134 in the gap between the first side frame 600 (the second side frame 700) and the flexible display 300.

There are a plurality of optional implementations for disposing the limiting portion 134. The following provides two implementations as examples.

A first implementation of the limiting portion 134 is as follows: Refer to FIG. 10, FIG. 14, FIG. 18, and FIG. 19. The limiting portion 134 includes a flexible portion 134a and a reinforcement portion 134b, the flexible portion 134a is connected to the flexible body 132, the reinforcement portion 134b is embedded in the flexible portion 134a, and the limiting portion 134, the elastic sheet 131, and the flexible body 132 are of an integrally formed structure.

The flexible portion 134a is easily injection-molded, and the reinforcement portion 134b has specific rigidity and strength. A structure having the limiting portion 134, the elastic sheet 131, and the flexible body 132 is manufactured in an integral forming manner. The flexible portion 134a and the reinforcement portion 134b are combined to complement each other, and are connected stably. Connections between the flexible portion 134a and the reinforcement portion 134b in the limiting portion 134, between the flexible portion 134a and the flexible body 132, and between the flexible body 132 and the elastic sheet 131 are reliable.

The reinforcement portion 134b may be made of metal or plastic, and the flexible portion 134a may be made of a same material as the flexible body 132. When an integrated insert injection-molded structure is used, the reinforcement portion 134b and the elastic sheet 131 are used as inserts, and the flexible portion 134a and the flexible body 132 are injection-molded, to form the flexible embedded member 130 having the limiting portion 134. The flexible portion 134a may be approximately sheet-shaped, and the reinforcement portion 134b may be approximately sheet-shaped, so that the limiting portion 134 obtained through insert injection molding is small in thickness.

For example, as shown in FIG. 14 and FIG. 19, the flexible portion 134a has a second groove 1341, and the reinforcement portion 134b is embedded in the second groove 1341. The flexible portion 134a wraps the reinforcement portion 134b, to increase a connection area between the flexible portion 134a and the reinforcement portion 134b, so that the flexible portion 134a and the reinforcement portion 134b are reliably connected. The second groove 1341 may be provided on a side that is of the flexible portion 134a and that faces the side surface 300c of the flexible display 300.

For example, as shown in FIG. 10, FIG. 14, FIG. 18, and FIG. 19, the reinforcement portion 134b has a second fitting hole 1343, the flexible portion 134a has a second fitting column 1342, the second fitting column 1342 is embedded in the second fitting hole 1343, and a wall surface of the second fitting hole 1343 is connected to an outer circumferential surface of the second fitting column 1342. The reinforcement portion 134b is used as an insert. In a process in which the flexible portion 134a is injection-molded, the second fitting hole 1343 of the reinforcement portion 134b is filled with a part of an injection molding material, and the injection molding material in the second fitting hole 1343 is cooled and cured to form the second fitting column 1342. The wall surface of the second fitting hole 1343 is connected to the outer circumferential surface of the second fitting column 1342, to increase a connection area between the flexible portion 134a and the reinforcement portion 134b, so that the flexible portion 134a and the reinforcement portion 134b are closely connected.

A second implementation of the limiting portion 134 is as follows: The limiting portion 134 is the flexible portion 134a, the flexible portion 134a is connected to the flexible body 132, and the limiting portion 134, the elastic sheet 131, and the flexible body 132 are of an integrally formed structure. A structure having the limiting portion 134, the elastic sheet 131, and the flexible body 132 is manufactured in an integral forming manner. The structure is easily molded, and connections between the flexible portion 134a and the flexible body 132 and between the flexible body 132 and the elastic sheet 131 are reliable.

In some other embodiments, no limiting portion 134 may be disposed at the two ends of the flexible embedded member 130. The two ends 130b of the flexible embedded member 130 are respectively disposed in the first gap 611 formed between the first side frame 600 and the display surface 300a of the flexible display 300, and the second gap 612 formed between the second side frame 700 and the display surface 300a of the flexible display 300, so that the flexible embedded member 130 can be limited.

During confirmation of the edge protection assembly 100 and the foldable device 1000 in embodiments of this application, the device may be disassembled for analysis. When a to-be-confirmed object is the edge protection assembly 100, it is to be confirmed that the middle part 130a of the flexible embedded member 130 in the edge protection assembly 100 in the length direction is connected to the supporting member 120, the flexible embedded member 130 includes the elastic sheet 131 and the flexible body 132, and the elastic sheet 131 is embedded in the flexible body 132. When the to-be-confirmed object is the device, it is to be confirmed that the device has the foldable flexible display 300, and the edge protection assembly 100 is disposed on the edge of the bending region 302 of the display surface 300a of the flexible display 300.

In conclusion, the foregoing descriptions are merely specific implementations of this application, but are not intended to limit the protection scope of this application. Any variation or replacement within the technical scope disclosed in this application shall fall within the protection scope of this application. Therefore, the protection scope of this application shall be subject to the protection scope of the claims.

## Claims

1. An edge protection assembly, applied to a foldable device having a hinge assembly and a flexible display, wherein the edge protection assembly comprises: a fastening member, a supporting member, and a flexible embedded member;
the fastening member is configured to be fastened to the hinge assembly; and in an axial direction of the hinge assembly, a projection of the fastening member covers a part of a side surface of the flexible display;
the supporting member is fastened to the fastening member; and
in a thickness direction of the flexible display, a projection of the flexible embedded member covers an edge of a bending region of a display surface of the flexible display; a middle part of the flexible embedded member in a length direction is connected to the supporting member; and the flexible embedded member comprises an elastic sheet and a flexible body, the elastic sheet is embedded in the flexible body, and the elastic sheet and the flexible body are of an integrally formed structure.

2. The edge protection assembly according to claim 1, wherein the elastic sheet has a first surface and a second surface that face away from each other, the first surface and the edge of the bending region of the display surface of the flexible display are disposed facing each other, and the flexible body is disposed on the second surface.

3. The edge protection assembly according to claim 1 or 2, wherein the elastic sheet is a plastic sheet or a metal sheet, a material of the flexible body is soft adhesive, and the elastic sheet and the flexible body are of an insert injection-molded structure; and/or
there is a first groove on a side that is of the flexible body and that faces the display surface of the flexible display, and the elastic sheet is embedded in the first groove.

4. The edge protection assembly according to any one of claims 1 to 3, wherein the fastening member has a protruding first positioning portion, the supporting member has a protruding second positioning portion, and the first positioning portion and the second positioning portion clamp the middle part of the flexible embedded member.

5. The edge protection assembly according to claim 4, wherein a third positioning portion is disposed between the first positioning portion and the second positioning portion, the middle part of the flexible embedded member in the length direction has a positioning hole, and the third positioning portion penetrates the positioning hole.

6. The edge protection assembly according to claim 5, wherein the third positioning portion is disposed on a side that is of the second positioning portion and that faces the first positioning portion, and an end that is of the third positioning portion and that faces away from the second positioning portion is connected to or in contact with the first positioning portion.

7. The edge protection assembly according to any one of claims 1 to 3, wherein the flexible body comprises a strip portion and a connecting portion, the strip portion is connected to the elastic sheet, the strip portion has a first side surface facing the fastening member, and the connecting portion is connected to a middle part of the first side surface of the strip portion; and the supporting member is embedded in the connecting portion, and the supporting member, the elastic sheet, and the flexible body are of an integrally formed structure.

8. The edge protection assembly according to claim 7, wherein the supporting member comprises a supporting portion and an assembly portion connected to the supporting portion, the supporting portion is embedded in the connecting portion, and the assembly portion is connected to the fastening member.

9. The edge protection assembly according to claim 8, wherein the connecting portion is located between the fastening member and the supporting portion, there is an accommodating groove on a side that is of the fastening member and that faces the supporting member, and the connecting portion is embedded in the accommodating groove;
the supporting portion has a first fitting hole, the connecting portion has a first fitting column, the first fitting column is embedded in the first fitting hole, and a wall surface of the first fitting hole is connected to an outer circumferential surface of the first fitting column; and/or
the supporting portion has a bent section that bends and extends toward the strip portion, and the bent section is embedded in a connection region between the connecting portion and the strip portion.

10. The edge protection assembly according to any one of claims 1 to 9, wherein there is a limiting portion at each of two ends of a side surface that is of the flexible embedded member and that faces the fastening member, and the limiting portion extends in the thickness direction of the flexible display.

11. The edge protection assembly according to claim 10, wherein the limiting portion comprises a flexible portion and a reinforcement portion, the flexible portion is connected to the flexible body, the reinforcement portion is embedded in the flexible portion, and the limiting portion, the elastic sheet, and the flexible body are of an integrally formed structure.

12. The edge protection assembly according to claim 11, wherein the flexible portion has a second groove, and the reinforcement portion is embedded in the second groove; and/or
the reinforcement portion has a second fitting hole, the flexible portion has a second fitting column, the second fitting column is embedded in the second fitting hole, and a wall surface of the second fitting hole is connected to an outer circumferential surface of the second fitting column.

13. The edge protection assembly according to any one of claims 1 to 12, wherein there is a mounting groove on a side that is of the fastening member and that faces the flexible embedded member, and the supporting member is embedded in the mounting groove;
the fastening member is bonded through adhesive, snap-fitted, welded, or connected through a fastener to the supporting member;
a material of the fastening member is metal or plastic; and/or
a material of the supporting member is metal or plastic.

14. A foldable device, comprising: a hinge assembly, a first main body, a second main body, a flexible display, and the edge protection assembly according to any one of claims 1 to 13, wherein
the hinge assembly is located between the first main body and the second main body, and the first main body and the second main body are connected through the hinge assembly;
the flexible display has a display surface and a back surface that face away from each other, and the back surface of the flexible display is fastened to the first main body and the second main body; and
the fastening member is fastened to the hinge assembly, and the supporting member is fastened to a side that is of the fastening member and that faces the flexible display.

15. The foldable device according to claim 14, wherein a first side frame is disposed on the first main body, and the first side frame is disposed on an edge that is of the flexible display and that corresponds to the first main body; a second side frame is disposed on the second main body, and the second side frame is disposed on an edge that is of the flexible display and that corresponds to the second main body; and the edge protection assembly is located between the first side frame and the second side frame.

16. The foldable device according to claim 15, wherein in a thickness direction of the flexible display, a first gap is formed between the first side frame and the display surface of the flexible display, and a second gap is formed between the second side frame and the display surface of the flexible display; and one end of the flexible embedded member is located in the first gap, and the other end of the flexible embedded member is located in the second gap.

17. The foldable device according to claim 15 or 16, wherein there is the limiting portion at each of the two ends of the side surface that is of the flexible embedded member and that faces the fastening member, in an axial direction of the hinge assembly, a third gap is formed between the first side frame and a side surface of the flexible display, and a fourth gap is formed between the second side frame and the side surface of the flexible display; and the limiting portion at one end of the flexible embedded member is located in the third gap, and the limiting portion at the other end of the flexible embedded member is located in the fourth gap.

18. The foldable device according to any one of claims 15 to 17, wherein there is a first shielding portion at a position that is of the first side frame and that is close to the hinge assembly, and there is a second shielding portion at a position that is of the second side frame and that is close to the hinge assembly; and in the axial direction of the hinge assembly, a projection of the first shielding portion partially covers the fastening member, and a projection of the second shielding portion partially covers the fastening member.
